# EUROPEAN PATENT SPECIFICATION

(11) **EP 4 398 302 B1**
(45) Date of publication and mention of the grant of the patent: **14.01.2026**
(21) Application number: 23219127.0
(22) Date of filing: 21.12.2023
(51) Int. Cl.: H10F 39/00

(54) **IMAGE SENSOR HAVING META-PHOTONIC STRUCTURE AND ELECTRONIC APPARATUS INCLUDING THE IMAGE SENSOR**
BILDSENSOR MIT METAPHOTONISCHER STRUKTUR UND ELEKTRONISCHE VORRICHTUNG MIT DEM BILDSENSOR
CAPTEUR D'IMAGE AYANT UNE STRUCTURE MÉTAPHOTONIQUE ET APPAREIL ÉLECTRONIQUE COMPRENANT LE CAPTEUR D'IMAGE

(30) Priority: 09.01.2023 KR 20230003031
(43) Date of publication of application: 10.07.2024
(73) Proprietor: Samsung Electronics Co., Ltd., Suwon-si, Gyeonggi-do 16677 (KR)
(72) Inventor: PARK, Hongkyu, 16678, Suwon-si, (KR); PARK, Hyeonsoo, 16678, Suwon-si, (KR); CHA, Jungho, 16678, Suwon-si, (KR); LIM, Minwoo, 16678, Suwon-si, (KR)
(74) Representative: Elkington and Fife LLP

(56) References cited:
- EP-A1- 3 993 044
- KR-A- 20220 058 389
- US-A1- 2022 208 822

## Description

### FIELD OF THE INVENTION

One or more embodiments relate to an image sensor including a meta-photonic structure and an electronic apparatus including the image sensor.

### BACKGROUND OF THE INVENTION

Image sensors generally sense the color of incident light by using a color filter. However, a color filter may have low light utilization efficiency because the color filter absorbs light of colors other than the intended color of light. For example, in the case in which a red-green-blue (RGB) color filter is used, only 1/3 of the incident light is transmitted therethrough and the other portion of the incident light, that is, 2/3 of the incident light, is absorbed. Thus, the light utilization efficiency of the RGB color filter is only about 33%. As a result, in a color display apparatus or a color image sensor, most light loss occurs in the color filter. In order to reduce the light loss, a method of applying various optical structures to a surface of an image sensor has been suggested. However, these methods involve a high level of complexity and high costs for manufacturing an image sensor.

EP 3993044 A1 discloses an image sensor including a spectrum shaping layer configured to shape a spectral profile of the light incident on the sensor substrate.

KR 2022 0058389 A discloses an image sensor having a color separation lens array which can separate incident light by each wavelength to condense the same.

US 2022/208822 A1 discloses an image sensor including a planar nanophotonic microlens array, and an electronic device including the image sensor.

### SUMMARY OF THE INVENTION

Provided are image sensors including a meta-photonic structure.

Provided are image sensors having a crack stopper.

Provided are electronic devices including the image sensors.

Additional aspects will be set forth in part in the description which follows and, in part, will be apparent from the description, or may be learned by practice of the presented embodiments of the disclosure.

According to one embodiments, there is provided an image sensor according to claim 1.

An interval between the crack stopper and the active pixel sensor region may be ten times or greater than a width of each of the plurality of pixels.

A width of the crack stopper may be greater than or equal to a width of the nano-structure from among the plurality of nano-structures.

The width of the crack stopper may be about 200 nm to about 2 µm.

An inside of the crack stopper is filled with a first material, the plurality of nano-structures are filled with a second material, and the first material is a same material as the second material.

A bottom surface and at least one sidewall of the groove shape of the crack stopper are coated with a material of the plurality of nano-structures and a void remains at a center portion in the groove shape of the crack stopper after the bottom surface and the at least one sidewall of the groove shape of the crack stopper are coated.

The crack stopper may be continuously extended along a circumference of the active pixel sensor region with an interval between the crack stopper and the active pixel sensor region.

The crack stopper is a first crack stopper surrounding the active pixel sensor region with a first interval between the active pixel sensor region and the first crack stopper and the periphery region further comprises a second crack stopper surrounding the first crack stopper with a second interval between the first crack stopper and the second crack stopper.

The periphery region may comprise an optical black region that surrounds the active pixel sensor region and outputs a dark signal, and the crack stopper may be arranged in the optical black region.

The meta-photonic structure of the active pixel sensor region may be extended to a portion of the optical black region, and the plurality of nano-structures in the meta-photonic structure arranged in a portion of the optical black region may be arranged to come into contact with the boundary of the active pixel sensor region.

An interval between the nano-structure that is closest to the crack stopper and the crack stopper may be ten times or greater than a width of each of the plurality of pixels.

The active pixel sensor region may further include a color filter layer arranged between the sensor layer and the meta-photonic structure, and the optical black region may further include a light shielding layer arranged between the sensor layer and the dielectric layer.

The optical black region may further include a blue color filter between the light shielding layer and the meta-photonic structure.

The active pixel sensor region and the optical black region may further include a planarization layer that extends from the active pixel sensor region to the optical black region, in the active pixel sensor region, the planarization layer may be arranged between the color filter layer and the meta-photonic structure, and in the optical black region, the planarization layer may be arranged between the light shielding layer and the dielectric layer.

The planarization layer may further include a first planarization layer formed of an organic polymer material, and a second planarization layer disposed on the first planarization layer and formed of an inorganic material.

The meta-photonic structure may include a first meta-photonic structure layer having a plurality of first nano-structures and a second meta-photonic structure layer disposed on the first meta-photonic structure layer and having a plurality of second nano-structures, the dielectric layer may include a first dielectric layer filled among the plurality of first nano-structures and a second dielectric layer filled among the plurality of second nano-structures, and the first dielectric layer and the second dielectric layer may be integrally extended from the active pixel sensor region to the periphery region.

The image sensor may further include an etch stop layer between the first meta-photonic structure layer and the second meta-photonic structure layer.

The crack stopper is a first crack stopper layer disposed in the first dielectric layer and the periphery region further comprises a second crack stopper layer disposed in the second dielectric layer.

One of the first crack stopper layer and the second crack stopper layer is continuously extended through the first dielectric layer and the second dielectric layer.

The image sensor further comprises: an anti-reflection layer disposed on an upper surface of the meta-photonic structure, wherein the anti-reflection layer integrally extends from the active pixel sensor region to the periphery region, and the anti-reflection layer covers an upper surface of the crack stopper.

According to one or more embodiments, an image sensor includes a sensor layer including a plurality of pixels outputting pixel signals for generating an image, a meta-photonic structure arranged facing the sensor layer and including a plurality of nano-structures, and a crack stopper arranged at a same layer as the meta-photonic structure so as to surround the plurality of nano-structures.

According to one or more embodiments, there is provided an electronic apparatus according to claim 14.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram of an image sensor according to one or more embodiments;
FIG. 2 is a diagram showing an example in which a plurality of regions having different functions are arranged in an image sensor according to one or more embodiments;
FIG. 3 is a cross-sectional view schematically showing an example structure of the image sensor of FIG. 2 according to one or more embodiments;
FIG. 4 is a diagram showing an example in which a plurality of regions having different functions are arranged in an image sensor according to one or more embodiments;
FIG. 5 is a cross-sectional view schematically showing an example structure of the image sensor of FIG. 4 according to one or more embodiments;
FIG. 6 is a cross-sectional view schematically showing an example structure of an image sensor according to one or more embodiments;
FIG. 7 is a cross-sectional view schematically showing an example structure of an image sensor according to one or more embodiments;
FIG. 8 is a cross-sectional view schematically showing an example structure of an image sensor according to one or more embodiments;
FIG. 9 is a cross-sectional view schematically showing an example structure of an image sensor according to one or more embodiments;
FIG. 10 is a cross-sectional view schematically showing an example structure of an image sensor according to one or more embodiments;
FIGS. 11A to 11C are diagrams showing various examples of pixel arrangement in an active pixel sensor region in an image sensor according to one or more embodiments;
FIGS. 12A and 12B are cross-sectional views schematically showing a structure of an active pixel sensor region in an image sensor according to one or more embodiments;
FIG. 13 is a plan view schematically showing a structure of a sensor layer in an active pixel sensor region shown in FIGS. 12A and 12B according to one or more embodiments;
FIG. 14 is a plan view schematically showing a structure of a color filter layer of FIGS. 12A and 12B according to one or more embodiments;
FIG. 15 is a block diagram of an electronic apparatus including an image sensor according to one or more embodiments; and
FIG. 16 is a schematic block diagram of a camera module in FIG. 15 according to one or more embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. Expressions such as "at least one of," when preceding a list of elements, modify the entire list of elements and do not modify the individual elements of the list.

Hereinafter, an image sensor including a meta-photonic structure and an electronic apparatus including the image sensor will be described in detail with reference to accompanying drawings. The embodiments of the disclosure are capable of various modifications and may be embodied in many different forms. In the drawings, like reference numerals denote like components, and sizes of components in the drawings may be exaggerated for convenience of explanation.

When a layer, a film, a region, or a panel is referred to as being "on" another element, it may be directly on/under/at left/right sides of the other layer or substrate, or intervening layers may also be present.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprising" another component, the portion may not exclude another component but may further comprise another component unless the context states otherwise.

In addition, the terms such as "... unit", "module", etc. provided herein indicates a unit performing a function or operation, and may be realized by hardware, software, or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe technical detail, and the scope of rights is not limited by these terms unless the context is limited by the claims.

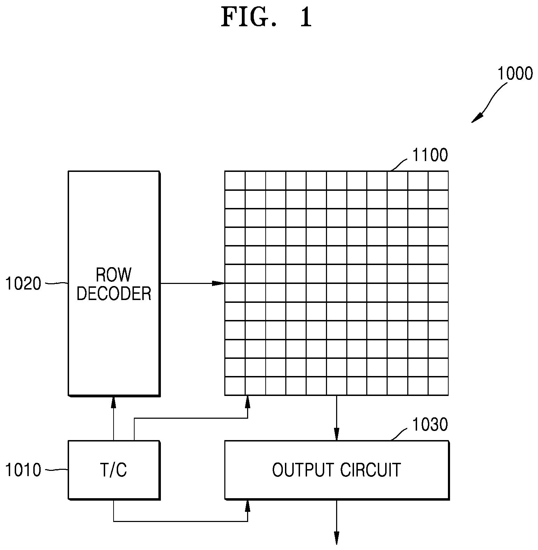

FIG. 1 is a schematic block diagram of an image sensor 1000 according to one or more embodiments. Referring to FIG. 1, the image sensor 1000 may include a pixel array 1100, a timing controller 1010, a row decoder 1020, and an output circuit 1030. The image sensor 1000 may include a charge-coupled device (CCD) image sensor or a complementary metal oxide semiconductor (CMOS) image sensor.

The pixel array 1100 includes pixels that are two-dimensionally arranged in a plurality of rows and columns. The row decoder 1020 selects one of the rows in the pixel array 1100 in response to a row address signal output from the timing controller 1010. The output circuit 1030 outputs a photosensitive signal, in a column unit, from a plurality of pixels arranged in the selected row. For example, the output circuit 1030 may include a column decoder and an analog-to-digital converter (ADC). For example, the output circuit 1030 may include a plurality of ADCs that are arranged respectively to columns between the column decoder and the pixel array 1100, or one ADC arranged at an output end of the column decoder. The timing controller (T/C) 1010, the row decoder 1020, and the output circuit 1030 may be implemented as one chip or in separate chips. A processor for processing an image signal output from the output circuit 1030 may be implemented as one or more chips with the timing controller 1010, the row decoder 1020, and the output circuit 1030. Although FIG. 1 illustrates a square shaped pixel array, the pixel array may be any suitable shape such as a rectangular shape.

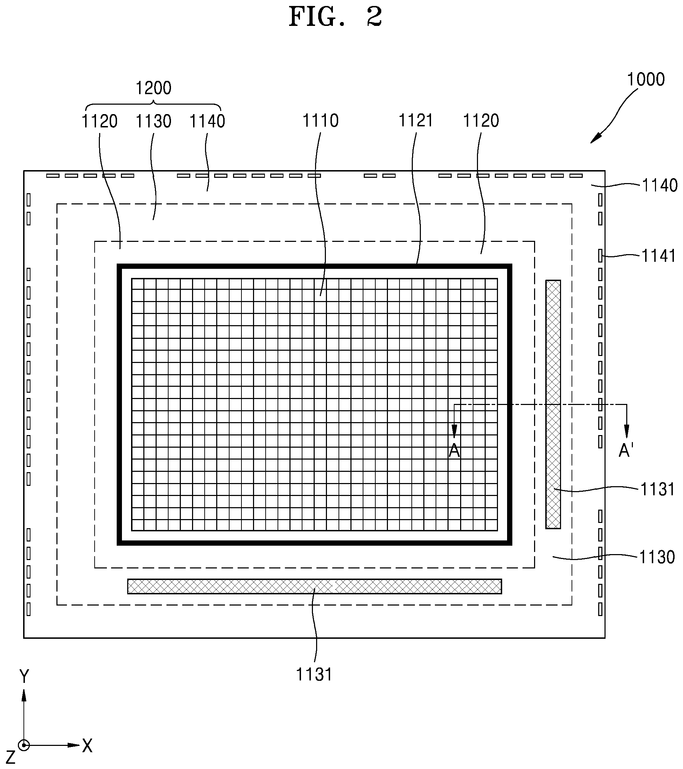

The image sensor 1000 may be divided into a plurality of regions having different functions. FIG. 2 is a diagram showing an example in which a plurality of regions having different functions are arranged in the image sensor 1000 according to one or more embodiments. Referring to FIG. 2, the image sensor 1000 may include an active pixel sensor region 1110 for outputting pixel signals for generating images, and a periphery region 1200 arranged to surround the periphery of the active pixel sensor region 1110. According to one or more embodiments, the periphery region 1200 may include a plurality of regions. For example, the periphery region 1200 may include an optical black region 1120 that is arranged to surround the periphery of the active pixel sensor region 1110 and is configured to output a dark signal, a back via stack region 1130 that is arranged to surround a periphery of the optical black region 1120 and has wirings for electrical connection between upper and lower layers in the image sensor 1000, and a contact pad region 1140 that is arranged to surround a periphery of the back via stack region 1130 and has contact pads 1141 for inputting/outputting signals to/from outside of the image sensor 1000.

In one or more examples, the active pixel sensor region 1110 may be a region in which pixels for outputting pixel signals that are used directly to generate images are formed. The active pixel sensor region 1110 may correspond to the pixel array 1100 of FIG. 1. The active pixel sensor region 1110 may be arranged at a center portion of the image sensor 1000. Some or all of the pixels included in the active pixel sensor region 1110 sense light of a certain wavelength band, for example, light of a certain color, from the light incident on the active pixel sensor region 1110, and output pixel signals based on an intensity of a color component included in the incident light. The active pixel sensor region 1110 may include three or more types of pixels, for example, green pixels for sensing an intensity of a green light component in the incident light, red pixels for sensing an intensity of a red light component, and blue pixels for sensing an intensity of a blue light component. The image sensor 1000 may generate an image by using pixel signals output from the pixels arranged in the active pixel sensor region 1110, and as the number of pixels in the active pixel sensor region 1110 increases, an image of a high resolution may be generated.

In one or more examples, the optical black region 1120 may be a region in which pixels outputting pixel signals without incident light, for example, dark signals, are formed. A dark signal may have an RGB value of 000, or approximately 000. The optical black region 1120 may be arranged to surround the periphery of the active pixel sensor region 1110. The optical black region 1120 may include pixels sensing the light, such as the active pixel sensor region 1110, but differs from the active pixel sensor region 1110 in that the optical black region 1120 includes a light shielding layer for shielding light that is incident on the pixels. The pixels arranged in the optical black region 1120 may output the dark signals that are noise signals generated due to a material forming a photodiode included in the pixels or due to a pixel structure, while the incident light is blocked. The dark signal may be used as a reference signal for correcting noise of pixel signals output from the active pixel sensor region 1110.

In one or more examples, the optical black region 1120 may further include a crack stopper 1121 surrounding the active pixel sensor region 1110. The crack stopper 1121 may be arranged in the optical black region 1120 to surround the active pixel sensor region 1110 with a gap interposed between the crack stopper 1121 and the active pixel sensor region 1110. The crack stopper 1121 may prevent cracks, which may occur in the edge of the image sensor 1000 during manufacturing the image sensor 100, from propagating to a meta-photonic structure arranged in the active pixel sensor region 1110. For example, the crack stopper 1121 may be formed as a groove by etching a portion of the upper surface of the optical black region 1120. Since the optical black region 1120 is a portion of the periphery region 1200, the crack stopper 1121 may be considered to be arranged in the periphery region 1200.

The back via stack region 1130 may include a plurality of back via stacks 1131 for electrical connection between the upper and lower layers in the image sensor 1000. The back via stack region 1130 may be arranged to surround the periphery of the optical black region 1120. The plurality of back via stacks 1131 may be arranged in the back via stack region 1130 at one or more intervals from the optical black region 1120. In FIG. 2, two back via stacks 1131 are shown as an example, but the number of the back via stacks 1131 is not limited thereto. In one or more examples, each of the back via stacks 1131 is shown to be extended lengthily in a first direction (e.g., X-direction) or a second direction (e.g., Y-direction) while facing one side of the optical black region 1120, but a plurality of back via stacks 1131 may be arranged in the first direction or the second direction with certain (e.g., predetermined) intervals therebetween.

The contact pad region 1140 may include a plurality of contact pads 1141 for signal input/output between the image sensor 1000 and an external device. The contact pad region 1140 may be arranged to surround the periphery of the back via stack region 1130. The number and locations of the plurality of contact pads 1141 are not limited to those shown in the drawings, and if necessary, may be varied according to design. The plurality of contact pads 1141 may be electrically connected to an input/output circuit in the image sensor 1000.

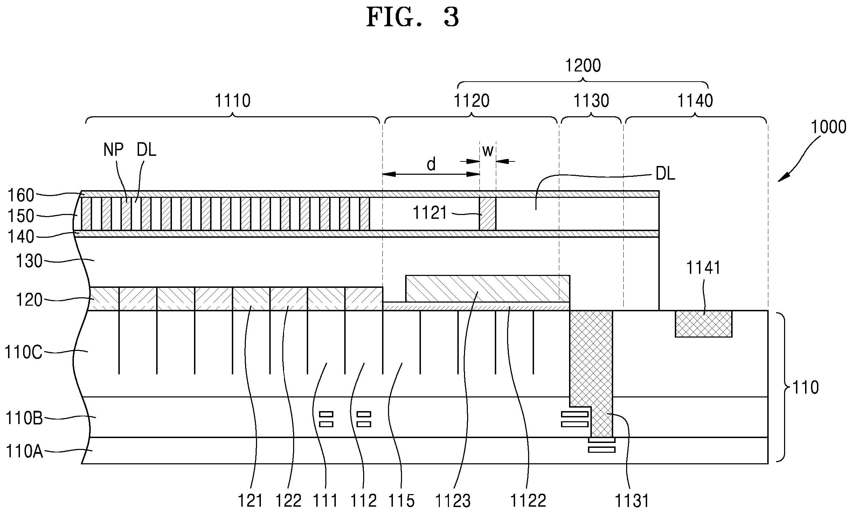

FIG. 3 is a cross-sectional view schematically showing an example structure of the image sensor 1000 of FIG. 2. In particular, FIG. 3 shows a cross-sectional structure of a part in the image sensor 1000 taken along line A-A' of FIG. 2. A ratio of sizes between components shown in FIG. 3 may be exaggerated for convenience of description and may be different from a ratio of sizes between actual components. FIG. 3 shows the components relevant to the embodiment for convenience of description, and the other components that are not necessary for describing the embodiment are omitted. Therefore, the image sensor 1000 may include components that are not shown in FIG. 3.

Referring to FIG. 3, the image sensor 1000 may include the active pixel sensor region 1110 and the periphery region 1200 that are divided on an XY plane according to functions thereof as described above with reference to FIG. 2, and the periphery region 1200 may include the optical black region 1120, the back via stack region 1130, and the contact pad region 1140. The active pixel sensor region 1110 and the periphery region 1200, for example, the active pixel sensor region 1110, the optical black region 1120, the back via stack region 1130, and the contact pad region 1140 may commonly include a substrate 110. In one or more examples, the substrate 110 may extend through the active pixel sensor region 1110, optical black region 1120, the back via stack region 1130, and the contact pad region 1140. In the substrate 110 and on the upper surface of the substrate 110, the active pixel sensor region 1110, the optical black region 1120, the back via stack region 1130, and the contact pad region 1140 may have different layered-structures from one another. For example these regions may be formed with different materials and/or formed with different shapes or thicknesses.

The substrate 110 may include a plurality of layers that are stacked in a third direction (e.g., Z-direction) and have different functions from one another. For example, the substrate 110 may include a lower chip 110A, an upper chip 110B on the lower chip 110A, and a sensor layer 110C on the upper chip 110B. The lower chip 110A, the upper chip 110B, and the sensor layer 110C may extend through the active pixel sensor region 1110 and the periphery region 1200. In one or more examples, the lower chip 110A, the upper chip 110B, and the sensor layer 110C may be arranged while extending through the active pixel sensor region 1110, the optical black region 1120, the back via stack region 1130, and the contact pad region 1140. A logic circuit for driving the image sensor 1000 may be arranged in the lower chip 110A. For example, the timing controller 1010 and the row decoder 1020 shown in FIG. 1 may be arranged in the lower chip 110A, and a processor may be arranged in the lower chip 110A. Circuits for outputting signals from the sensor layer 110C may be arranged in the upper chip 110B. For example, the output circuit 1030 shown in FIG. 1 may be arranged in the upper chip 110B. In one or more examples, an amplification circuit for amplifying signals may be arranged in the upper chip 110B. A plurality of photosensitive elements for converting incident light into electrical signals may be arranged in the sensor layer 110C. For example, the sensor layer 110C may include a plurality of photodiodes.

The active pixel sensor region 1110 may include a color filter layer 120 disposed on the upper surface of the substrate 110, a planarization layer 130 arranged to cover the color filter layer 120, and a meta-photonic structure 150 disposed on the planarization layer 130. The color filter layer 120, the planarization layer 130, and a meta-photonic structure 150 may be sequentially stacked on the substrate 110 in the third direction. Therefore, the meta-photonic structure 150 may be arranged facing the color filter layer 120 and the substrate 110, for example, the sensor layer 110C of the substrate 110, with the planarization layer 130 interposed therebetween. The color filter layer 120 may be arranged between the sensor layer 110C of the substrate 110 and a meta-photonic structure 150 or between the sensor layer 110C of the substrate 110 and the planarization layer 130, and the planarization layer 130 may be arranged between the color filter layer 120 and the meta-photonic structure 150. In one or more examples, the active pixel sensor region 1110 may further include an etch stop layer 140 between the planarization layer 130 and the meta-photonic structure 150. In one or more examples, the active pixel sensor region 1110 may further include an anti-reflection layer 160 on the upper surface of the meta-photonic structure 150. Therefore, the meta-photonic structure 150 may be arranged between the etch stop layer 140 and the anti-reflection layer 160.

In the active pixel sensor region 1110, the sensor layer 110C of the substrate 110 may include a plurality of pixels 111 and 112 that are two-dimensionally arranged in the first direction and the second direction (e.g. x and y directions). Each of the plurality of pixels 111 and 112 may include a photodiode. The color filter layer 120 may include a plurality of color filters 121 and 122 that are two-dimensionally arranged in the first direction and the second direction. The planarization layer 130 disposed on the color filter layer 120 may provide a flat surface for forming the meta-photonic structure 150. The meta-photonic structure 150 may separate the incident light according to wavelengths and/or may condense the incident light to be provided respectively to the plurality of pixels 111 and 112. For example, the meta-photonic structure 150 may include a plurality of nano-structures NP arranged to have a meta-pattern and a dielectric layer DL filled among the plurality of nano-structures NP. The nano-structures NP may include a material having a higher refractive index than that of a material included in the dielectric layer DL. Structures and functions of the sensor layer 110C, the color filter layer 120, the planarization layer 130, and the meta-photonic structure 150 will be described in detail later.

In one or more examples, the planarization layer 130, the etch stop layer 140, the dielectric layer DL, and the anti-reflection layer 160 may be integrally extended from the active pixel sensor region 1110 to the periphery region 1200. For example, the planarization layer 130, the etch stop layer 140, the dielectric layer DL, and the anti-reflection layer may be extended from the active pixel sensor region 1110 to the optical black region 1120, the back via stack region 1130, and the contact pad region 1140.

The optical black region 1120 may include a light shielding layer 1122 disposed on an upper surface of the substrate 110, such as, the sensor layer 110C, the planarization layer 130 covering the light shielding layer 1122, and the dielectric layer DL disposed on the planarization layer 130. The planarization layer 130 and the dielectric layer DL of the optical black region 1120 may be extended from the planarization layer 130 and the dielectric layer DL of the active pixel sensor region 1110 in the first direction and the second direction. In one or more examples, the planarization layer 130 and the dielectric layer DL may be extended through the active pixel sensor region 1110 and the optical black region 1120. The dielectric layer DL may be arranged facing the light shielding layer 1122 and the substrate 110, such as, the sensor layer 110C of the substrate 110, with the planarization layer 130 therebetween. In one or more examples, the light shielding layer 1122 may be arranged between the sensor layer 110C and the dielectric layer DL or between the sensor layer 110C and the planarization layer 130, and the planarization layer 130 may be arranged between the light shielding layer 1122 and the dielectric layer DL.

In one or more examples, the optical black region 1120 may further include the etch stop layer 140 between the planarization layer 130 and the dielectric layer DL. The anti-reflection layer 160 may further be disposed on the upper surface of the dielectric layer DL. The etch stop layer 140 and the anti-reflection layer 160 of the optical black region 1120 may be integrally extended from the etch stop layer 140 and the anti-reflection layer 160 of the active pixel sensor region 1110 in the first direction and the second direction. In one or more examples, the etch stop layer 140 and the anti-reflection layer 160 may be extended through the active pixel sensor region 1110 and the optical black region 1120. For example, the etch stop layer 140 may be a layer that starts in the active pixel sensor region 1110 and extends through the optical black region 1120. Furthermore, the anti-reflection layer 160 may be a layer that starts in the active pixel sensor region 1110 and extends through the optical black region 1120.

The optical black region 1120 may further include a blue color filter 1123 disposed on the light shielding layer 1122. In FIG. 3, the blue color filter 1123 may be directly disposed on the upper surface of the light shielding layer 1122, however, an interlayer material may be further provided between the light shielding layer 1122 and the blue color filter 1123 according to the necessity in the manufacturing processes of the image sensor 1000. The blue color filter 1123 may be arranged between the light shielding layer 1122 and the dielectric layer DL or between the light shielding layer 1122 and the planarization layer 130.

The light shielding layer 1122 may be arranged through the entire optical black region 1120. The light shielding layer 1122 may perform a blocking function on the light incident on the optical black region 1120 to prevent the light from being incident on the substrate 110, for example, the sensor layer 110C. The light shielding layer 1122 may include a material that may reflect or absorb visible light, including, but not limited to, chrome, copper, tungsten, manganese dioxide, carbon block, graphite, etc.

The blue color filter 1123 may prevent green light or red light that is not absorbed but reflected by the light shielding layer 1122, from being incident on the pixels 111 and 112 in the active pixel sensor region 1110 through scattering. **In** one or more examples, the blue light having relatively short wavelength is easily absorbed and has relatively short propagation distance, while the green light or red light having relatively long wavelength has relatively long propagation distance. Therefore, the green light or red light that is not absorbed but reflected by the light shielding layer 1122 is likely to be incident on the pixels 111 and 112 in the active pixel sensor region 1110. The blue color filter 1123 may advantageously prevent or reduce the green light or red light that is not absorbed by the light shielding layer 1122 from being incident on the pixels 111 and 112 in the active pixel sensor region 1110, by absorbing the green light and the red light from the incident light incident on the optical black region 1120.

In one or more examples, the sensor layer 110C of the substrate 110 in the optical black region 1120 may include a plurality of pixels 115 that are two-dimensionally arranged in the first direction and the second direction. The light shielding layer 1122 may be arranged to cover the plurality of pixels 115. Therefore, the incident light that is incident on the optical black region 1120 does not reach the plurality of pixels 115, and the plurality of pixels 115 in the optical black region 1120 may output dark signals.

In the optical black region 1120, the dielectric layer DL may not include nano-structures NP that are arranged to have a meta-pattern. In one or more examples, the optical black region 1120 may include the crack stopper 1121 formed in the dielectric layer DL in the form of a groove. For example, the crack stopper 1121 may be formed by etching one or more regions of the dielectric layer DL. Therefore, the crack stopper 1121 may be located at the same layer as that of the meta-photonic structure 150 of the active pixel sensor region 1110, and may have the same thickness as that of the meta-photonic structure 150. In one or more examples, the crack stopper 1121 formed in the shape of the groove may be filled with the same material as that of the nano-structures NP in the meta-photonic structure 150.

The crack stopper 1121 may be formed simultaneously with the meta-photonic structure 150 in the process of forming the meta-photonic structure 150 in the active pixel sensor region 1110. For example, the dielectric layer DL may be simultaneously formed on the active pixel sensor region 1110 and the optical black region 1120. In one or more examples, the dielectric layer DL of the active pixel sensor region 1110 and the dielectric layer DL of the optical black region 1120 may be integrally formed (e.g., the DL is one layer in both the active pixel sensor region 1110 and the optical black region 1120). After the DL is formed, when patterning the dielectric layer DL before forming the nano-structures NP of the meta-photonic structure 150 in the active pixel sensor region 1110, the dielectric layer DL in the optical black region 1120 may also be etched and the crack stopper 1121 may be formed. In one or more examples, when the material of the nano-structures NP is filled in the pattern of the dielectric layer DL in the active pixel sensor region 1110, the groove of the crack stopper 1121 may be also filled with the same material used to fill the nano-structures NP. Therefore, an additional process for forming the crack stopper 1121 is not necessary. Since the anti-reflection layer 160 is formed after forming the meta-photonic structure 150 and the crack stopper 1121, the upper surface of the crack stopper 1121 may be covered by the anti-reflection layer 160 on the dielectric layer DL. Therefore, the crack stopper 1121 may be disposed between the etch stop layer 140 and the anti-reflection layer 160 in a same manner as the meta-photonic structure 150.

According to one or more embodiments, the crack stopper 1121 may be continuously extended along the boundary of the active pixel sensor region 1110, as shown in FIG. 2. For example, the crack stopper 1121 may extend so as to surround the plurality of nano-structures NP of the meta-photonic structure 150, at the same layer as the meta-photonic structure 150 in the active pixel sensor region 1110. Therefore, the crack stopper 1121 may form a closed loop on a plane including the first direction and the second direction. In one or more examples, in order to reduce the influence of the crack reaching the crack stopper 1121 on the meta-photonic structure 150 in the active pixel sensor region 1110, the crack stopper 1121 may be arranged at a certain (e.g., predetermined) distance d from the last nano-structure NP of the meta-photonic structure 150 or from the active pixel sensor region 1110 in the first direction or the second direction. The last nano-structure NP of the meta-photonic structure 150 may correspond to a nano-structure NP that is closest to the crack stopper 1121. For example, the distance d in the first or second direction between the crack stopper 1121 and the last nano-structure NP of the meta-photonic structure 150 or the distance d in the first or second direction between the crack stopper 1121 and the active pixel sensor region 1110 may be ten times or greater of the width of each of the pixels 111 and 112 in the active pixel sensor region 1110 in the first or second direction. Furthermore, a total width of the optical black region 1120 in the first direction or the second direction may be about 20 times to 40 times or less of the width of each pixel 111 or 112 in the active pixel sensor region 1110 in the first or second direction. Therefore, a maximum value of the distance d in the first or second direction between the crack stopper 1121 and the last nano-structure NP of the meta-photonic structure 150 or the distance d in the first or second direction between the crack stopper 1121 and the active pixel sensor region 1110 may be 20 times or less, or 40 times or less of the width of each of the pixels 111 and 112 in the active pixel sensor region 1110 in the first or second direction.

Furthermore, in order for the crack stopper 1121 to stop the crack, the crack stopper 1121 may have a sufficiently large width. For example, a width w of the crack stopper 1121 in the first direction or the second direction may be equal to or greater than a width of a nano-structure NP having the largest width from among the plurality of nano-structures NP in the meta-photonic structure 150 in the first or second direction. For example, the width w of the crack stopper 1121 in the first or second direction may be about 200 nm or greater, 300 nm or greater, or 400 nm or greater. Furthermore, in consideration of a limitation due to etching equipment, the width w of the crack stopper 1121 in the first or second direction may be about 2 µm or less.

The back via stack region 1130 may include a plurality of back via stacks 1131 extending in the third direction in the substrate 110. For example, each of the plurality of back via stacks 1131 extends in the third direction along the lower chip 110A, the upper chip 110B, and the sensor layer 110C, and may electrically connect circuits or elements between the lower chip 110A and the upper chip 110B, circuits or elements between the upper chip 110B and the sensor layer 110C, or circuits or elements between the lower chip 110A and the sensor layer 110C.

In one or more examples, the light shielding layer 1122 and the blue color filter 1123 of the optical black region 1120 may be extended to a portion of the back via stack region 1130. Therefore, the light that is slightly incident on the back via stack region 1130 may be prevented from being incident on the pixel 115 in the optical black region 1120 while avoiding the light shielding layer 1122 and the blue color filter 1123.

The back via stack region 1130 may also include the planarization layer 130 covering the blue color filter 1123 and the substrate 110, the etch stop layer 140 on the planarization layer 130, the dielectric layer DL on the etch stop layer 140, and the anti-reflection layer 160 on the dielectric layer DL. The planarization layer 130, the etch stop layer 140, the dielectric layer DL, and the anti-reflection layer 160 of the back via stack region 1130 may be integrally extended from the active pixel sensor region 1110 in the first direction and the second direction. The planarization layer 130 of the back via stack region 1130 may be in direct contact with a portion of the upper surface of the substrate 110 (e.g., layer 110C) and upper surfaces of the plurality of back via stacks 1131. In one or more examples, in an area corresponding to the back via stack region 1130, the dielectric layer DL does not include the nano-structures NP that are arranged to have a meta-pattern and the crack stopper 1121.

The contact pad region 1140 may include a plurality of contact pads 1141, as illustrated in FIG. 2, disposed on the upper surface of the substrate 110. The plurality of contact pads 1141 may be electrically connected to input/output circuits in the image sensor 1000. For example, the plurality of contact pads 1141 may be electrically connected to the circuits or elements in the lower chip 110A, the upper chip 110B, or the sensor layer 110C. The plurality of contact pads 1141 may be disposed on the upper surface of the substrate 110, or may be embedded in the upper surface of the substrate 110.

In order to form the plurality of contact pads 1141, the planarization layer 130, the etch stop layer 140, the dielectric layer DL, and the anti-reflection layer 160 may be etched in the contact pad region so as to expose an edge of the upper surface of the substrate 110. For example, before the contact pad 1141 is formed, the antireflection layer 160, the dielectric layer DL, etch stop layer 140, and planarization layer may extend to the edge of the substrate 110, where each of these layers may be etched to expose a top surface of the substrate 110. The plurality of contact pads 1141 may be arranged on the exposed edge of the upper surface of the substrate 110. Therefore, the planarization layer 130, the etch stop layer 140, the dielectric layer DL, and the anti-reflection layer 160 may be extended only to a portion of the contact pad region 1140. However, one or more embodiments are not limited thereto, and as understood by one of ordinary skill in the art, the planarization layer 130, the etch stop layer 140, the dielectric layer DL, and the anti-reflection layer 160 may be etched in the entire contact pad region 1140. In one or more examples, the planarization layer 130, the etch stop layer 140, the dielectric layer DL, and the anti-reflection layer 160 may be extended only to a portion of the back via stack region 1130.

A photodiode may not be formed in the sensor layer 110C in the back via stack region 1130 and the contact pad region 1140. In one or more examples, the back via stack region 1130 and the contact pad region 1140 do not include pixels for sensing light. In FIG. 3, the thickness of the substrate 110, such as, the thickness of the sensor is consistent in the back via stack region 1130, the contact pad region 1140, the active pixel sensor region 1110, and the optical black region 1120,. However, as understood by one of ordinary skill in the art, the embodiments are not limited these configurations. For example, because there is no photodiode in the sensor layer 110C in the back via stack region 1130 and the contact pad region 1140, the thickness of the sensor layer 110C in the back via stack region 1130 and the contact pad region 1140 may be less than that of the sensor layer 110C in the active pixel sensor region 1110 and the optical black region 1120. In one or more examples, there may be a step between the optical black region 1120 and the back via stack region 1130.

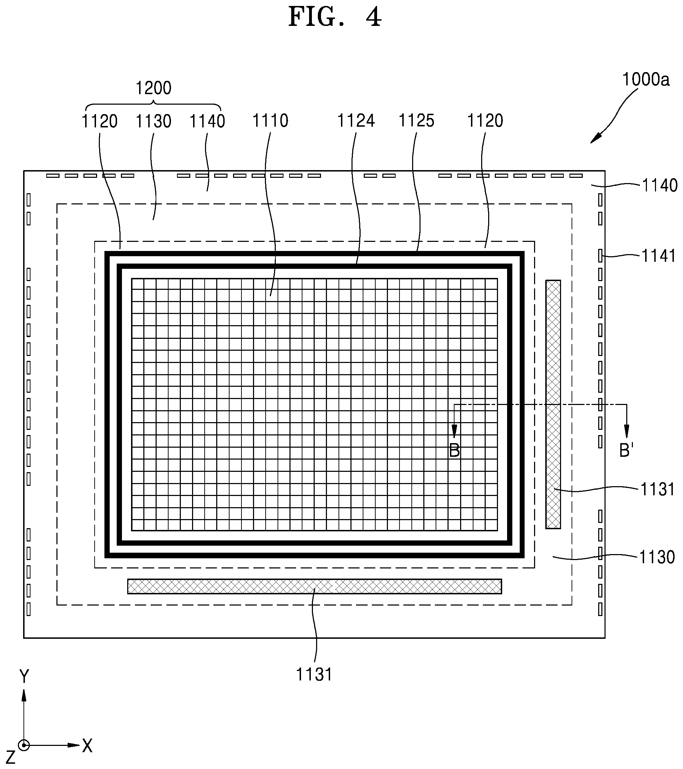

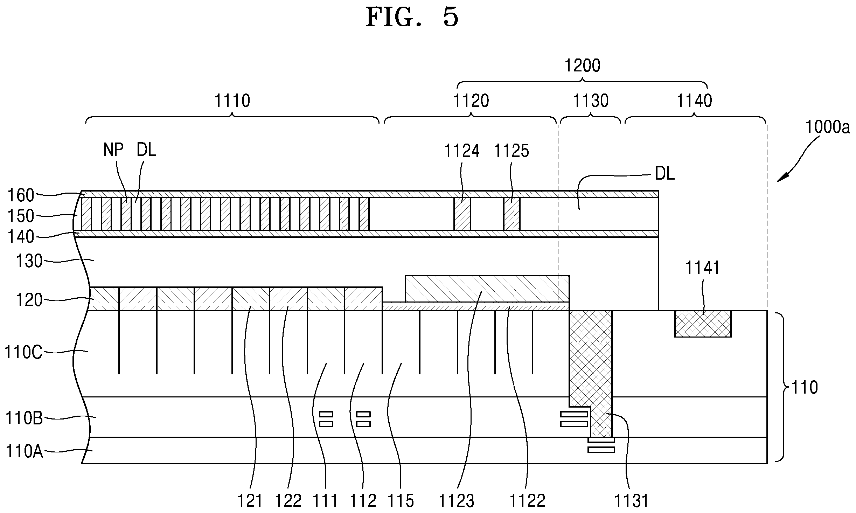

FIG. 4 is a diagram showing an example in which a plurality of regions having different functions are arranged in an image sensor 1000a according to one or more embodiments. FIG. 5 is a cross-sectional view schematically showing an example structure of the image sensor 1000a of FIG. 4 according to one or more embodiments. In particular, FIG. 5 shows a cross-sectional structure of a portion in the image sensor 1000a taken along line B-B' shown in FIG. 4 according to one or more embodiments.

Referring to FIGS. 4 and 5, the image sensor 1000a may include a plurality of crack stoppers 1124 and 1125. For example, the image sensor 1000a may include the first crack stopper 1124 and the second crack stopper 1125, where the first crack stopper 1124 may be arranged to surround the active pixel sensor region 1110 with an interval therebetween in the optical black region 1120 (e.g., distance between active pixel sensor region 1110 and first crack stopper 1124), and the second crack stopper 1125 may be arranged to surround the first crack stopper 1124 with an interval therebetween in the optical black region 1120 (e.g., interval between first crack stopper 1124 and the second crack stopper 1125 or the interval between the active pixel sensor region 1110 and the second crack stopper 1125). Although FIGS. 4 and 5 show two crack stoppers 1124 and 1125, as understood by one of ordinary skill in the art, the embodiments are not limited to these configurations. For example, the image sensor 1000a may include three or more crack stoppers. Except for the plurality of crack stoppers 1124 and 1125, the image sensor 1000a may have the same components as those of the image sensor 1000 described above with reference to FIGS. 2 and 3.

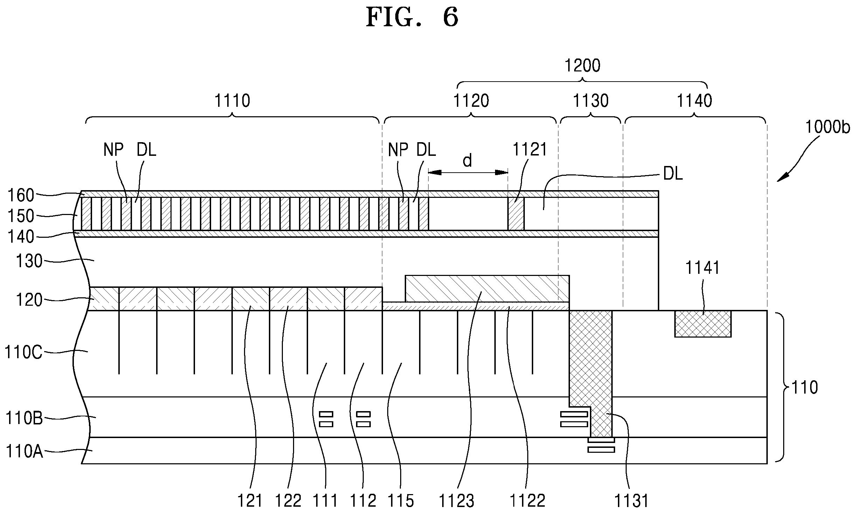

FIG. 6 is a cross-sectional view schematically showing an example structure of an image sensor 1000b according to one or more embodiments. Referring to FIG. 6, in the image sensor 1000b, a plurality of nano-structures NP may be arranged to have a meta-pattern in a portion of the optical black region 1120. In one or more examples, the meta-photonic structure 150 of the active pixel sensor region 1110 may extend to a portion of the optical black region 1120. Therefore, the plurality of nano-structures NP arranged in a portion of the optical black region 1120 are arranged adjacent to the nano-structures NP in the active pixel sensor region 1110, and may be arranged to surround the active pixel sensor region 1110 and contact the circumference of the active pixel sensor region 1110. The plurality of nano-structures NP arranged in the optical black region 1120 may provide the pixels arranged at the edges of the active pixel sensor region 1110 with light, so as to contribute to the improvement in the light utilizing efficiency and color purity. Except that the plurality of nano-structures NP are further arranged in the optical black region 1120, the image sensor 1000b may include the same components as those of the image sensor 1000 described above with reference to FIGS. 2 and 3.

When the plurality of nano-structures NP are arranged in the optical black region 1120, the crack stopper 1121 may be arranged at a distance d from the last nano-structure NP in the optical black region 1120 in the first direction or the second direction. For example, when the distance d in the first or second direction between the crack stopper 1121 and the last nano-structure NP in the optical black region 1120 may be ten times the width of each pixel 111 or 112 in the active pixel sensor region 1110 in the first direction or second direction or greater. In one or more examples, when the distance d in the first or second direction between the crack stopper 1121 and the nano-structure NP that is closest to the crack stopper 1121 in the first or second direction may be ten times or greater the width of each pixel 111 or 112 in the active pixel sensor region 1110 in the first or second direction.

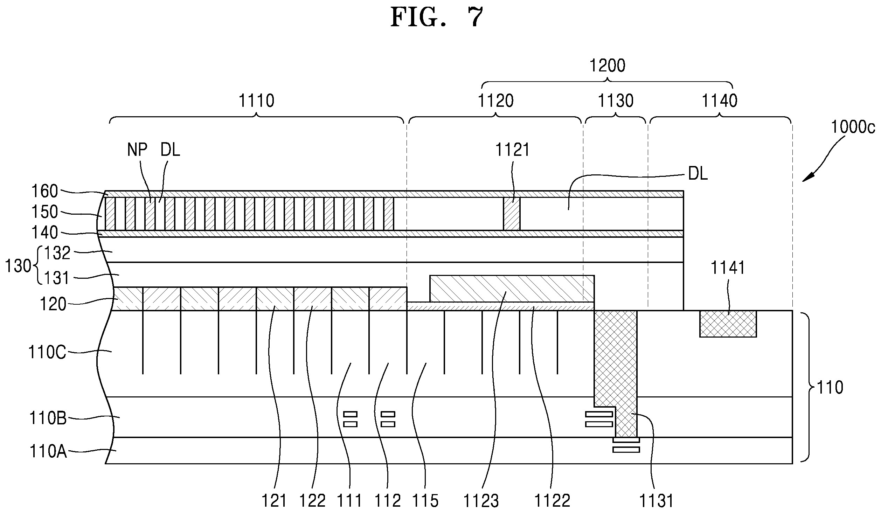

FIG. 7 is a cross-sectional view schematically showing an example structure of the image sensor 1000c according to one or more embodiments. Referring to FIG. 7, the planarization layer 130 of the image sensor 1000c may include a first planarization layer 131 formed of an organic polymer material and a second planarization layer 132 preventing damage to the first planarization layer 131. The first planarization layer 131 may include an organic polymer material that is suitable for being stacked on the color filter layer 120. The color filter layer 120 may be formed of an organic material and may easily form a flat surface. The second planarization layer 132 may function as a protective layer that prevents damage to the first planarization layer 131 formed of an organic polymer material during a process of forming the meta-photonic structure 150. To achieve these advantageous results, the second planarization layer 132 may include an inorganic material. The first planarization layer 131 may be directly disposed on the color filter layer 120, and the second planarization layer 132 may be directly disposed on the first planarization layer 131. In one or more examples, the second planarization layer 132 may be disposed between the first planarization layer 131 and the meta-photonic structure 150 in the active pixel sensor region 1110, and between the first planarization layer 131 and the dielectric layer DL in the periphery region 1200. The components of the image sensor 1000b other than the first planarization layer 131 and the second planarization layer 132 may be the same as those of the image sensor 1000 described above with reference to FIGS. 2 and 3.

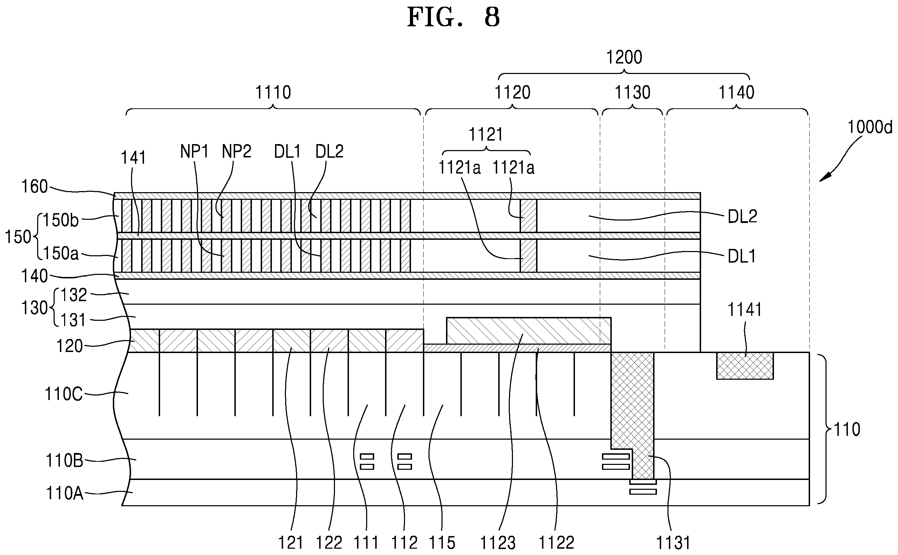

FIG. 8 is a cross-sectional view schematically showing an example structure of an image sensor 1000d according to one or more embodiments. Referring to FIG. 8, meta-photonic structure 150 of the active pixel sensor region 1110 in the image sensor 1000d may have a multi-layered structure. For example, the meta-photonic structure 150 may include a first meta-photonic structure layer 150a disposed on the second planarization layer 132 and a second meta-photonic structure layer 150b disposed on the first meta-photonic structure layer 150a. The first meta-photonic structure layer 150a may include a plurality of first nano-structures NP1 and a first dielectric layer DL1 filled among the plurality of first nano-structures NP1, and the second meta-photonic structure layer 150b may include a plurality of second nano-structures NP2 and a second dielectric layer DL2 filled among the plurality of second nano-structures NP2. The arrangement of the first nano-structures NP1 in the first meta-photonic structure layer 150a and the arrangement of the second nano-structures NP2 in the second meta-photonic structure layer 150b may be the same as or different from each other. The meta-photonic structure 150 may be easily manufactured with less complexity and cost when the nano-structures NP are separately formed as the first nano-structures NP1 and the second nano-structures NP2, rather than forming the nano-structures NP as one layer having a large aspect ratio. In one or more examples, in order to improve the efficiency of the meta-photonic structure 150, the arrangement of the first nano-structures NP1 in the first meta-photonic structure layer 150a and the arrangement of the second nano-structures NP2 in the second meta-photonic structure layer 150b may be designed to be different from each other. For example, the first nano-structures NP1 in the first meta-photonic structure layer 150a may have a different width or vertical length than the second nano-structures NP2 in the second meta-photonic structure layer 150b.

In one or more examples, the image sensor 1000d may further include an etch stop layer 141 that is additionally arranged between the first meta-photonic structure layer 150a and the second meta-photonic structure layer 150b. In one or more examples, the etch stop layer 140 arranged between the second planarization layer 132 and the first meta-photonic structure layer 150a may be a first etch stop layer, and the etch stop layer 141 arranged between the first meta-photonic structure layer 150a and the second meta-photonic structure layer 150b may be a second etch stop layer.

The crack stopper 1121 of the image sensor 1000d may have a multi-layered structure. For example, the first dielectric layer DL1 and the second dielectric layer DL2 of the active pixel sensor region 1110 may be integrally extended from the active pixel sensor region 1110 to the periphery region 1200 in the first direction and the second direction. In one or more examples, the crack stopper 1121 may include a first crack stopper layer 1121a disposed on the first dielectric layer DL1 and a second crack stopper layer 1121b disposed on the second dielectric layer DL2. The second etch stop layer 141 may be disposed between the first crack stopper layer 1121a and the second crack stopper layer 1121b. Except for the meta-photonic structure 150 and the crack stopper 1121 having multi-layered structures, the components of the image sensor 1000d may be the same as those of the image sensor 1000c described above with reference to FIG. 7.

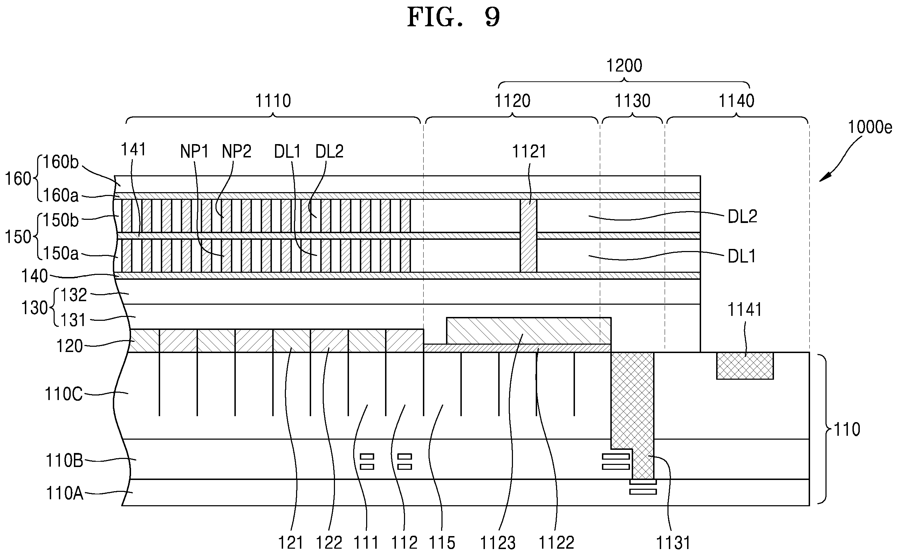

FIG. 9 is a cross-sectional view schematically showing an example structure of an image sensor 1000e according to one or more embodiments. Referring to FIG. 9, the anti-reflection layer 160 of the image sensor 1000e may include a first anti-reflection layer 160a disposed on the meta-photonic structure 150, and a second anti-reflection layer 160b disposed on the first anti-reflection layer 160a. The first anti-reflection layer 160a and the second anti-reflection layer 160b may include a material having a different refractive index from that of the material in the first and second nano-structures NP1 and NP2 of the meta-photonic structure 150. For example, an average refractive index of the first anti-reflection layer 160a and the second anti-reflection layer 160b may be greater than that of the air and less than an average refractive index of the meta-photonic structure 150. For example, the first anti-reflection layer 160a and the second anti-reflection layer 160b may include any one of SiO₂, Si₃N₄, and Al₂O₃. The first anti-reflection layer 160a and the second anti-reflection layer 160b may be formed of the same materials or different materials. The refractive index of the second anti-reflection layer 160b may be selected to be less than that of the first anti-reflection layer 160a. In one or more examples, a thickness of the second anti-reflection layer 160b may be greater than that of the first anti-reflection layer 160a. The first anti-reflection layer 160a and the second anti-reflection layer 160b may be integrally extended from the active pixel sensor region 1110 to the periphery region 1200.

In one or more examples, referring to FIG. 9, one crack stopper 1121 may be formed as one layer penetrating through the second etch stop layer 141. In one or more examples, one crack stopper 1121 between the first etch stop layer 140 and the anti-reflection layer 160 may be continuously extended in the third direction through the first dielectric layer DL1 and the second dielectric layer DL2. The other components of the image sensor 1000e than the anti-reflection layer 160 and the crack stopper 1121 may be the same as the components of the image sensor 1000d described above with reference to FIG. 8.

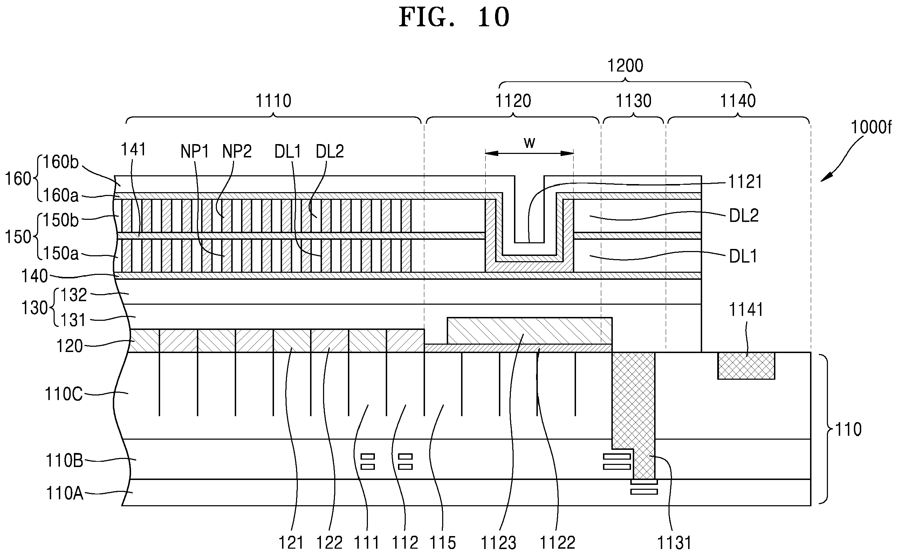

FIG. 10 is a cross-sectional view schematically showing an example structure of an image sensor 1000f according to one or more embodiments. Referring to FIG. 10, when the width w of the crack stopper 1121 in the first or second direction is sufficiently large in the image sensor 1000f, the inside of the groove may not be completely filled with the materials of the layers to be formed in the post-processes and there may be a void in the groove of the crack stopper 1121. For example, when the width w of the crack stopper 1121 in the first or second direction is greater than about 300 nm, or greater than about 400 nm, the materials of the nano-structures NP1 and NP2 and the material of the anti-reflection layer 160 may be coated on a bottom surface and side wall in the groove of the crack stopper 1121, and there may be a void at the center portion in the groove of the crack stopper 1121. The other components of the image sensor 1000f than the crack stopper 1121 may be the same as the components of the image sensor 1000e described above with reference to FIG. 9.

Furthermore, the active pixel sensor region 1110 may be a pixel array for outputting signals that are used directly to generate images. The active pixel sensor region 1110 may be configured to sense light of different wavelengths. Hereinafter, the structure of the active pixel sensor region 1110 will be described below in detail.

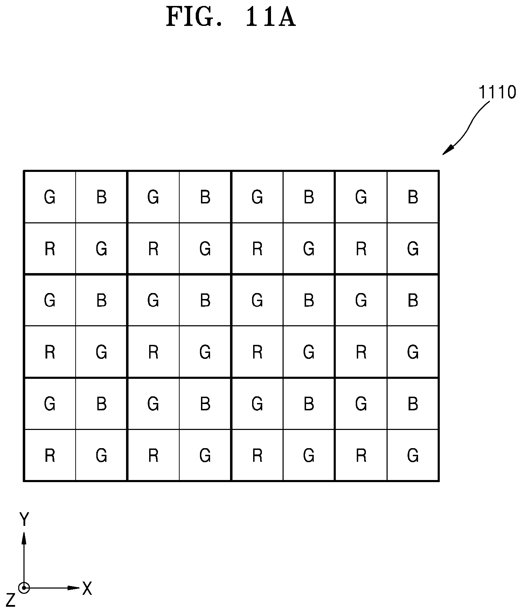

In the active pixel sensor region 1110, the pixels may be arranged in various types. For example, FIGS. 11A to 11C are diagrams showing examples of various pixel arrangements in the active pixel sensor region in the image sensor.

FIG. 11A shows a Bayer pattern that may be used in the image sensor. Referring to FIG. 11A, one unit pattern includes four quadrant regions, and first through fourth quadrants may be the blue pixel B (top right), the green pixel G (bottom right), the red pixel R (bottom left), and the green pixel G (top left), respectively. The unit patterns may be repeatedly and two-dimensionally arranged in a first direction and a second direction. For example, FIG. 11A illustrates a 3x4 two-dimensional arrangement of unit patters, where each unit pattern includes a 2x2 arrangement of pixels. In one or more examples, two green pixels G are arranged in one diagonal direction and one blue pixel B and one red pixel R are arranged in another diagonal direction in a unit pattern of a 2×2 array. In the entire arrangement of pixels, a first row in which a plurality of green pixels G and a plurality of blue pixels B are alternately arranged in the first direction and a second row in which a plurality of red pixels R and a plurality of green pixels G are alternately arranged in the first direction are repeatedly arranged in a second direction.

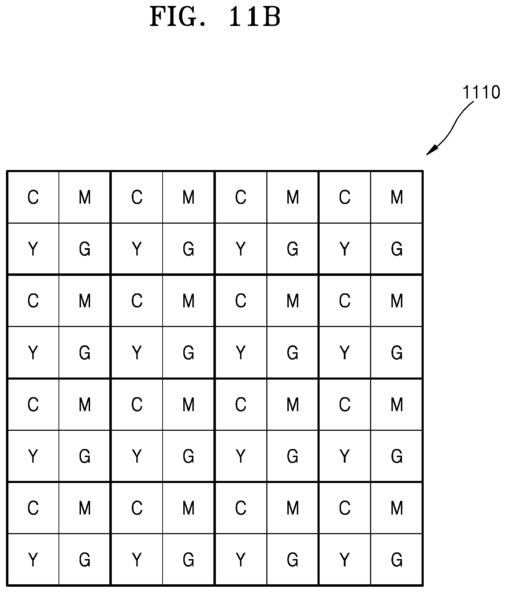

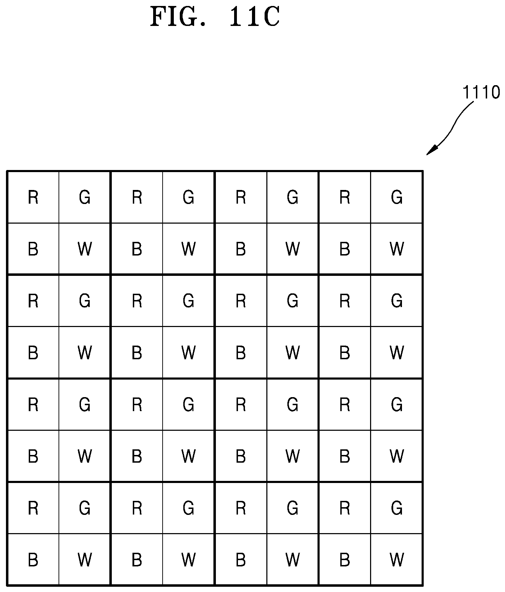

As understood by one of ordinary skill in the art, the pixels may be arranged in various arrangement patterns rather than the Bayer pattern. For example, referring to FIG. 11B, a CYGM arrangement, in which a magenta pixel M, a cyan pixel C, a yellow pixel Y, and a green pixel G corresponding to one unit pattern may be used. In one or more examples, referring to FIG. 11C, an RGBW arrangement, in which a green pixel G, a red pixel R, a blue pixel, and a white pixel W corresponding to one unit pattern may be used. In one or more examples, the unit pattern may have a 3×2 array form. In one or more examples, the pixels may be arranged in various types according to color characteristics of the image sensor. Hereinafter, an example in which the pixel arrangement in the active pixel sensor region 1110 has a Bayer pattern will be described, but the operating principles may be applied to other patterns of the pixel arrangement than the Bayer pattern.

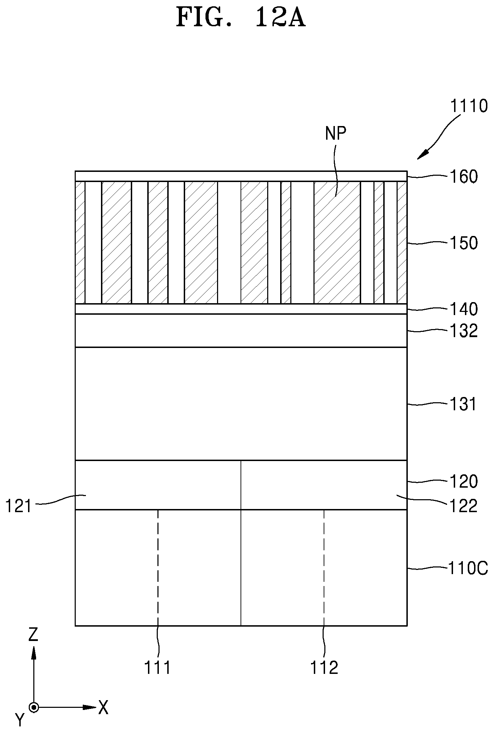

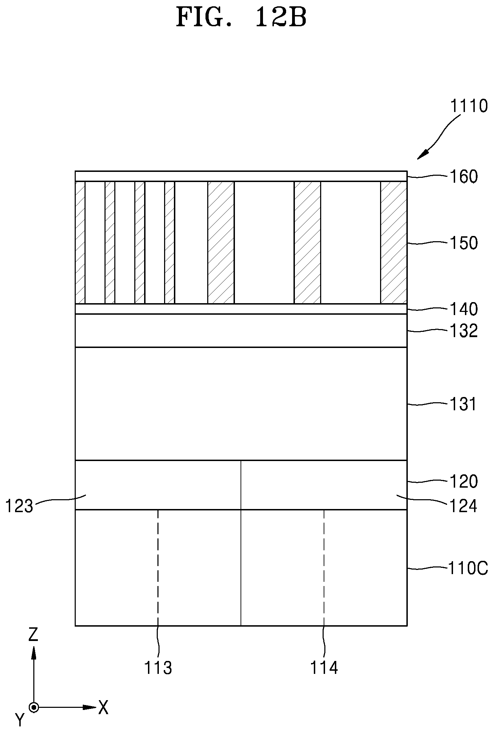

FIGS. 12A and 12B are cross-sectional views schematically showing a structure of the active pixel sensor region 1110 in an image sensor according to one or more embodiments. FIG. 12A shows a cross-section of the active pixel sensor region 1110 taken along the first direction, and FIG. 12B shows a cross-section of the active pixel sensor region 1110 taken along the first direction, in a cross-section different from that of FIG. 12A in the second direction. In FIGS. 12A and 12B, the sensor layer 110C of the substrate 110 is only shown.

Referring to FIGS. 12A and 12B, the active pixel sensor region 1110 may include the sensor layer 110C, the color filter layer 120 disposed on the sensor, the first planarization layer 131 that is transparent and disposed on the color filter layer 120, the second planarization layer 132 that is transparent and disposed on the first planarization layer 131, and the meta-photonic structure 150 disposed on the second planarization layer 132. In one or more examples, the active pixel sensor region 1110 may further include the etch stop layer 140 between the second planarization layer 132 and the meta-photonic structure 150. In one or more examples, the active pixel sensor region 1110 may further include the anti-reflection layer 160 on the light-incident surface of the meta-photonic structure 150. The etch stop layer 140 and the anti-reflection layer 160 may be omitted.

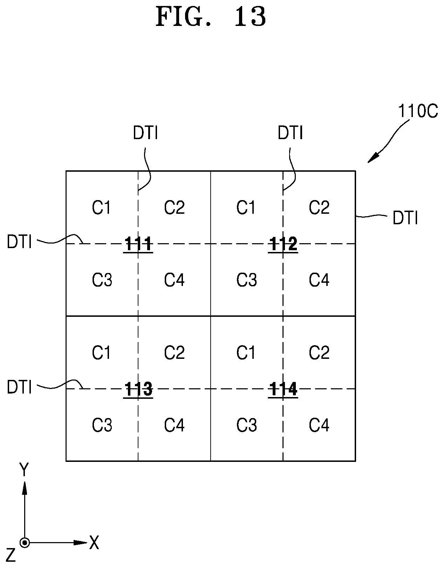

FIG. 13 is a plan view schematically showing the structure of the sensor layer 110C in the active pixel sensor region 1110 shown in FIGS. 12A and 12B. Referring to FIG. 13. the sensor layer 110C may include a plurality of pixels sensing incident light. For example, the sensor layer 110C may include a first pixel 111, a second pixel 112, a third pixel 113, and a fourth pixel 114 that convert incident light into electrical signals and generate an image signal. The first pixel 111, the second pixel 112, the third pixel 113, and the fourth pixel 114 may form one unit Bayer pattern. For example, the first and fourth pixels 111 and 114 may be green pixels sensing green light, the second pixel 112 may be a blue pixel sensing blue light, and the third pixel 113 may be a red pixel sensing red light.

FIGS. 12A, 12B, and 13 show only one unit Bayer pattern including four pixels. However, as understood by one of ordinary skill in the art, the active pixel sensor region 1110 may include a plurality of Bayer patterns that are two-dimensionally arranged. For example, a plurality of first pixels 111 and a plurality of second pixels 112 may be alternately arranged in a first direction, and a plurality of third pixels 113 and a plurality of fourth pixels 114 may be alternately arranged in the first direction on a cross-section located differently in a second direction perpendicular to the first direction.

In one or more examples, each of the first to fourth photosensitive cells 111, 112, 113, and 114 may include only one photodiode. In one or more examples, each of the first to fourth pixels 111, 112, 113, and 114 may be one unit photosensitive cell. In one or more examples, each of the first to fourth pixels 111, 112, 113, and 114 may include a plurality of photosensitive cells that independently sense incident light. For example, each of the first to fourth pixels 111, 112, 113, and 114 may include first to fourth photosensitive cells C1, C2, C3, and C4. The first to fourth photosensitive cells C1, C2, C3, and C4 may be two-dimensionally arranged in the first direction and the second direction. For example, in each of the first to fourth pixels 111, 112, 113, and 114, the first to fourth photosensitive cells C1, C2, C3, and C4 may be arranged in a 2x2 array.

FIG. 13 shows an example in which each of the first to fourth pixels 111, 112, 113, and 114 includes four photosensitive cells. However, as understood by one of ordinary skill in the art, four or more independent photosensitive cells may be grouped and two-dimensionally arranged. For example, each of the first to fourth pixels 111, 112, 113, and 114 may include a plurality of independent photosensitive cells that are grouped and arranged in a 3x3 array or 4x4 array.

When each of the first to fourth pixels 111, 112, 113, and 114 includes a plurality of photosensitive cells, an auto-focusing signal may be obtained from a difference between output signals from adjacent photosensitive cells. For example, an auto-focusing signal in the first direction (X-direction) may be generated from a difference between output signals from the first photosensitive cell C1 and the second photosensitive cell C2, a difference between output signals from the third photosensitive cell C3 and the fourth photosensitive cell C4, or a difference between a sum of the output signals from the first photosensitive cell C1 and the third photosensitive cell C3 and a sum of the output signals from the second photosensitive cell C2 and the fourth photosensitive cell C4 (e.g., (C1+C3) - (C2+C4)). In one or more examples, an auto-focusing signal in the second direction (Y-direction) may be generated from a difference between output signals from the first photosensitive cell C1 and the third photosensitive cell C3, a difference between output signals from the second photosensitive cell C2 and the fourth photosensitive cell C4, or a difference between a sum of the output signals from the first photosensitive cell C1 and the second photosensitive cell C2 and a sum of the output signals from the third photosensitive cell C3 and the fourth photosensitive cell C4 (e.g., (C1 +C2) - (C3+C4)).

In one or more examples, a general image signal may be obtained by summing output signals from the first to fourth photosensitive cells C1, C2, C3, and C4. For example, a first green image signal may be generated by summing the output signals from the first to fourth photosensitive cells C1, C2, C3, and C4 of the first pixel 111, a blue image signal may be generated by summing the output signals from the first to fourth photosensitive cells C1, C2, C3, and C4 of the second pixel 112, a red image signal may be generated by summing the output signals from the first to fourth photosensitive cells C1, C2, C3, and C4 of the third pixel 113, and a second green image signal may be generated by summing the output signals from the first to fourth photosensitive cells C1, C2, C3, and C4 of the fourth pixel 114.

In one or more examples, each of the first to fourth pixels 111, 112, 113, and 114 may include double trench isolations (DTI) that electrically isolate the plurality of photosensitive cells from one another. The DTI may have, for example, a deep trench isolation structure. The deep trench may be filled with air or an electrically insulating material. The DTI may extend in the first direction and the second direction so as to divide each of the first to fourth pixels 111, 112, 113, and 114 into four. The first to fourth photosensitive cells C1, C2, C3, and C4 in each of the first to fourth pixels 111, 112, 113, and 114 may be isolated from one another by the isolations DTI. The isolation DTI extending in the first direction and the isolation DTI extending in the second direction may cross each other at the center of each of the first to fourth pixels 111, 112, 113, and 114.

In one or more examples, the DTI may be arranged in the first direction and the second direction between adjacent pixels from among the first to fourth pixels 111, 112, 113, and 114. Therefore, the first to fourth pixels 111, 112, 113, and 114 may be isolated from one another due to the DTI. The isolation DTI extending in the first direction and the isolation DTI extending in the second direction may cross each other at the center of the unit Bayer pattern including the first to fourth pixels 111, 112, 113, and 114.

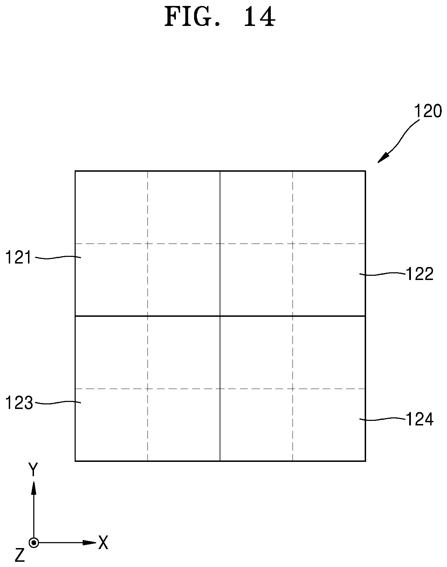

FIG. 14 is a plan view schematically showing a structure of the color filter layer 120 of FIGS. 12A and 12B. Referring to FIG. 14, the color filter layer 120 may include a plurality of color filters each transmitting light of a certain wavelength band and absorbing light of another wavelength band. For example, the color filter layer 120 may include a first color filter 121 transmitting light of a first wavelength band and absorbing light of another wavelength band, a second color filter 122 transmitting light of a second wavelength band that is different from the first wavelength band and absorbing light of another wavelength band, a third color filter 123 transmitting light of a third wavelength band that is different from the first and second wavelength bands and absorbing light of another wavelength band, and a fourth color filter 124 transmitting light of the first wavelength band and absorbing light of another wavelength band. FIG. 14 only shows an example of one unit Bayer pattern. However, as understood by one of ordinary skill in the art, a plurality of first color filters 121 and a plurality of second color filters 122 may be alternately arranged in the first direction, and a plurality of third color filters 123 and a plurality of fourth color filters 124 may be alternately arranged in the first direction on a cross-section that is at a different location in the second direction that is perpendicular to the first direction.

The first color filter 121 may be arranged to face the first pixel 111 in a third direction, the second color filter 122 may be arranged to face the second pixel 112 in the third direction, the third color filter 123 may be arranged to face the third pixel 113 in the third direction, and the fourth color filter 124 may be arranged to face the fourth pixel 114 in the third direction. Accordingly, the first pixel 111 and the fourth pixel 114 may sense the light of the first wavelength band that has passed through the first color filter 121 and the fourth color filter 124 respectively corresponding thereto. In one or more examples, the second pixel 112 may sense the light of the second wavelength band that has passed through the second color filter 122 corresponding thereto. The third pixel 113 may sense the light of the third wavelength band that has passed through the third color filter 123 corresponding thereto. For example, the first color filter 121 and the fourth color filter 124 may be green color filters transmitting the green light, the second color filter 122 may be a blue color filter transmitting the blue light, and the third color filter 123 may be a red color filter transmitting the red light.

In FIG. 14, dashed lines indicate the isolations between the photosensitive cells in the first to fourth pixels 111, 112, 113, and 114. As shown in FIG. 14, the first to fourth color filters 121, 122, 123, and 124 may be arranged to face all the photosensitive cells in the first to fourth pixels 111, 112, 113, and 114 respectively corresponding thereto in the third direction. In one or more examples, the first color filter 121 covers all photosensitive cells in the first pixel 111, the second color filter 122 covers all photosensitive cells in the second pixel 112, the third color filter 123 covers all photosensitive cells in the third pixel 113, and the fourth color filter 124 covers all photosensitive cells in the fourth pixel 114.

The first to fourth color filters 121, 122, 123, and 124 in the color filter layer 120 may be formed of, for example, an organic polymer material. For example, the first to fourth color filters 121, 122, 123, and 124 may include a coloring agent, binder resin, polymer photoresist, etc. The first and fourth color filters 121 and 124 may be organic color filters including green organic dye or a green organic pigment as a coloring agent, the second color filter 122 may be an organic color filter including a blue organic dye or a blue organic pigment as a coloring agent, and the third color filter 123 may be an organic color filter including a red organic dye or a red organic pigment as a coloring agent. In one or more examples, the color filter layer 120 may further include a black matrix arranged at boundaries between the first to fourth color filters 121, 122, 123, and 124. The black matrix may include, for example, carbon black.

In FIGS. 12A and 12B, although the color filter layer 120 is shown to have a flat upper surface for convenience's sake, the upper surface of each of the first to fourth color filters 121, 122, 123, and 124 may not be flat. In one or more examples, thicknesses of the first to fourth color filters 121, 122, 123, and 124 and the black matrix may not be identical to each other. The first planarization layer 131 disposed on the color filter layer 120 may provide a flat surface for forming the meta-photonic structure 150 thereon. The first planarization layer 131 may include an organic polymer material that is suitable for being stacked on the color filter layer 120 that is formed of an organic material and may easily form a flat surface. The organic polymer material forming the first planarization layer 131 may be transparent with respect to visible light. For example, the first planarization layer 131 may include at least one organic polymer material from an epoxy resin, polyimide, polycarbonate, polyacrylate, and polymethyl methacrylate (PMMA). The first planarization layer 131 may be formed on the color filter layer 120 by, for example, a spin coating method, and may have a flat upper surface through a thermal treatment.

In one or more examples, the second planarization layer 132 may be further disposed on the first planarization layer 131. The second planarization layer 132 may function as a protective layer that prevents damage to the first planarization layer 131 formed of an organic polymer material during a process of forming the meta-photonic structure 150 on the first planarization layer 131. In one or more examples, the encapsulation layer 131 may function as a diffusion barrier layer that prevents a metal component in the color filter layer 120 from passing through the first planarization layer 131 and being exposed to outside due to the high temperature during the process of forming the meta-photonic structure 150. To achieve these features, the second planarization layer 132 may include an inorganic material. The inorganic material of the second planarization layer 132 may be formed at a temperature lower than a processing temperature for forming the meta-photonic structure 150 and may include a material transparent with respect to visible light. In one or more examples, a refractive index of the second planarization layer 132 may be similar to that of the first planarization layer 131 in order to reduce reflection loss at an interface between the first planarization layer 131 and the second planarization layer 132. For example, a difference between the refractive index of the first planarization layer 131 and the refractive index of the second planarization layer 132 may be within ±20% of the refractive index of the first planarization layer 131. For example, the second planarization layer 132 may include at least one inorganic material selected from SiO₂, SiN, and SiON.

The structure and operations of the meta-photonic structure 150 shown in FIGS. 12A and 12B may be the same as those of a color separating lens array described in FIGS. 5B, 6A-6C, and 7A-7G and paragraphs [0086]-[0109], etc. of US Laid-open Patent Publication No. US 2022/02344399 A1 published on October 27, 2022, the entire contents of which are incorporated herein by reference. In one or more examples, the structure and operations of the meta-photonic structure 150 shown in FIGS. 12A and 12B may be the same as those of a planar nano-photonic microlens array described in FIGS. 6, 7A, and 7B and paragraphs [0073]-[0084], etc. of US Laid-open Patent Publication No. US 2023/0020980 A1 published on January 19, 2023, the entire contents of which are incorporated by references. In one or more examples, referring to FIG. 12A, the etch stop layer 140 arranged between the second planarization layer 132 and the meta-photonic structure 150 may protect the layers under the meta-photonic structure 150 during the process for forming the meta-photonic structure 150. The etch stop layer 140 may include a high-refractive index material that is not easily etched as compared with the second planarization layer 132 located thereunder and is transparent with respect to visible light. The etch stop layer 140 may include, for example, a material, such as Al₁O₃, HfO₂, etc. The thickness of the etch stop layer 140 may be about 5 nm to about 50 nm.

In one or more examples, the anti-reflection layer 160 disposed on the light-incident surface of the meta-photonic structure 150 may reduce the light reflected by the upper surface of the meta-photonic structure 150 and may improve the light utilization efficiency of the image sensor. The anti-reflection layer 160 may include a material having a refractive index different from that of the material of the nano-structures NP in the meta-photonic structure 150. In one or more examples, an average refractive index of the anti-reflection layer 160 may be greater than a refractive index of air and may be less than an average refractive index of the meta-photonic structure 150. For example, the anti-reflection layer 160 may include one layer formed of any one of SiO₂, Si₃N₄, and Al₂O₃. The anti-reflection layer 160 may be formed of a thickness of about 80 nm to about 120 nm. In one or more examples, the anti-reflection layer 160 may have a multi-layered structure in which different dielectric materials are alternately stacked. In one or more examples, the anti-reflection layer 160 may include various patterns for anti-reflection.

The image sensor may have an improved light utilization efficiency. As the light utilization efficiency is improved, a size of one pixel or size of independent photosensitive cells in the pixel of the image sensor may be reduced. Therefore, the image sensor having high resolution may be provided. The image sensor according to the embodiment may form a camera module along with a module lens of various functions and may be utilized in various electronic devices.

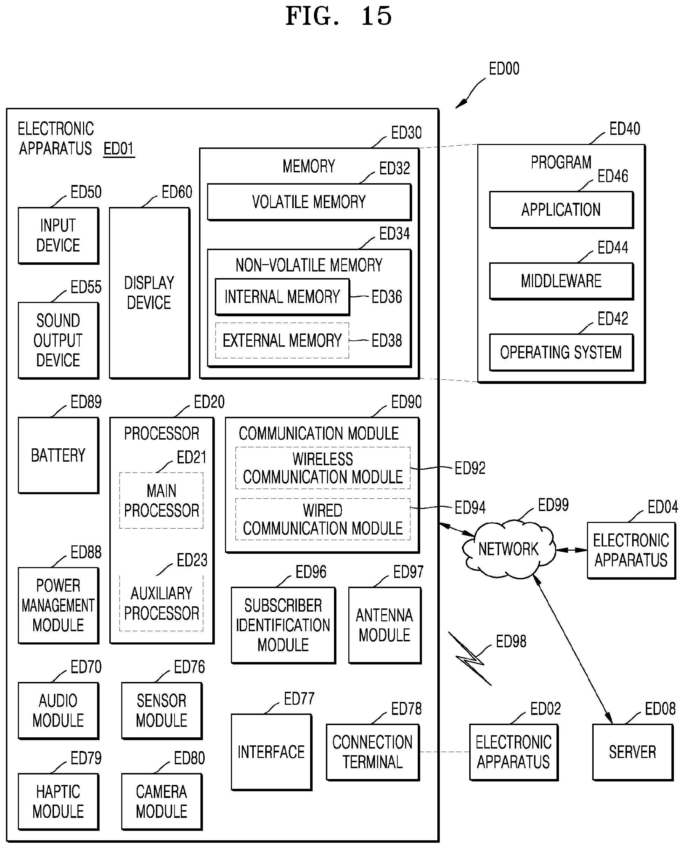

FIG. 15 is a block diagram showing an example of an electronic apparatus ED01 including the image sensor according to one or more embodiments. Referring to FIG. 15, in a network environment ED00, the electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.). The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, one or more of the elements (e.g., display device ED60, etc.) may be omitted or another element may be added. One or more of the elements may be configured as one integrated circuit. For example, the sensor module ED76 (e.g., a fingerprint sensor, an iris sensor, an illuminance sensor, etc.) may be embedded and implemented in the display device ED60 (display, etc.).

The processor ED20 may control one or more elements (e.g., hardware, software elements, etc.) of the electronic apparatus ED01 connected to the processor ED20 by executing software (program ED40, etc.), and may perform various data processes or operations. As a portion of the data processing or operations, the processor ED20 may load a command and/or data received from another element (e.g., sensor module ED76, communication module ED90, etc.) to a volatile memory ED32, may process the command and/or data stored in the volatile memory ED32, and may store result data in a non-volatile memory ED34. The processor ED20 may include a main processor ED21 (e.g., central processing unit, application processor, etc.) and an auxiliary processor ED23 (e.g., graphic processing unit, image signal processor, sensor hub processor, communication processor, etc.) that may be operated independently from or along with the main processor ED21. The auxiliary processor ED23 may use less power than that of the main processor ED21, and may perform specified functions.

The auxiliary processor ED23, on behalf of the main processor ED21 while the main processor ED21 may be in an inactive state (e.g., sleep state) or along with the main processor ED21 while the main processor ED21 is in an active state (e.g., application executed state), may control functions and/or states related to some (e.g., display device ED60, sensor module ED76, communication module ED90, etc.) of the elements in the electronic apparatus ED01. The auxiliary processor ED23 (e.g., image signal processor, communication processor, etc.) may be implemented as a part of another element (e.g., camera module ED80, communication module ED90, etc.) that is functionally related thereto.

The memory ED30 may store various data required by the elements (e.g., processor ED20, sensor module ED76, etc.) of the electronic apparatus ED01. The data may include, for example, input data and/or output data about software (e.g., program ED40, etc.) and commands related thereto. The memory ED30 may include the volatile memory ED32 and/or the non-volatile memory ED34.

The program ED40 may be stored as software in the memory ED30, and may include an operation system ED42, middleware ED44, and/or an application ED46.

The input device ED50 may receive commands and/or data to be used in the elements (e.g., processor ED20, etc.) of the electronic apparatus ED01, from outside (user, etc.) of the electronic apparatus ED01. The input device ED50 may include a microphone, a mouse, a keyboard, and/or a digital pen (e.g., stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (e.g., pressure sensor, etc.) that is set to measure a strength of a force generated by the touch.

The audio module ED70 may convert sound into an electrical signal or vice versa. The audio module ED 70 may acquire sound through the input device ED50, or may output sound via the sound output device ED55 and/or a speaker and/or a headphone of another electronic apparatus (e.g., electronic apparatus ED02, etc.) connected directly or wirelessly to the electronic apparatus ED01.

The sensor module ED76 may sense an operating state (e.g., power, temperature, etc.) of the electronic apparatus ED01, or an outer environmental state (e.g., user state, etc.), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (e.g., electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (e.g., electronic apparatus ED02, etc.). The connection terminal ED78 may include an HDMI connector, a USB connector, an SD card connector, and/or an audio connector (e.g., headphone connector, etc.).

The haptic module ED79 may convert the electrical signal into a mechanical stimulation (e.g., vibration, motion, etc.) or an electric stimulation that the user may sense through a tactile or motion sensation. The haptic module ED79 may include a motor, a piezoelectric device, and/or an electric stimulus device.

The camera module ED80 may capture a still image and a video. The camera module ED80 may include a lens assembly including one or more lenses, the image sensor according to the above-described embodiment, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (e.g., electronic apparatus ED02, electronic apparatus ED04, server ED08, etc.), and execution of communication through the established communication channel. The communication module ED90 may be operated independently from the processor ED20 (e.g., application processor, etc.), and may include one or more communication processors that support the direct communication and/or the wireless communication. The communication module ED90 may include a wireless communication module ED92 (e.g., cellular communication module, a short-range wireless communication module, a global navigation satellite system (GNSS) communication module) and/or a wired communication module ED94 (e.g., local area network (LAN) communication module, a power line communication module, etc.). From among the communication modules, a corresponding communication module may communicate with another electronic apparatus via a first network ED98 (e.g., short-range communication network such as Bluetooth, WiFi direct, or infrared data association (IrDA)) or a second network ED99 (e.g., long-range communication network such as a cellular network, Internet, or computer network (LAN, WAN, etc.)). Such above various kinds of communication modules may be integrated as one element (e.g., single chip, etc.) or may be implemented as a plurality of elements (e.g., a plurality of chips) separately from one another. The wireless communication module ED92 may identify and authenticate the electronic apparatus ED01 in a communication network such as the first network ED98 and/or the second network ED99 by using subscriber information (e.g., international mobile subscriber identifier (IMSI), etc.) stored in the subscriber identification module ED96.

The antenna module ED97 may transmit or receive the signal and/or power to/from outside (e.g., another electronic apparatus, etc.). An antenna may include a radiator formed as a conductive pattern formed on a substrate (e.g., PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component other than the antenna (e.g., RFIC, etc.) may be included as a portion of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (e.g., commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To achieve these features, for example, a cloud computing, a distributed computing, or a client-server computing technique may be used.

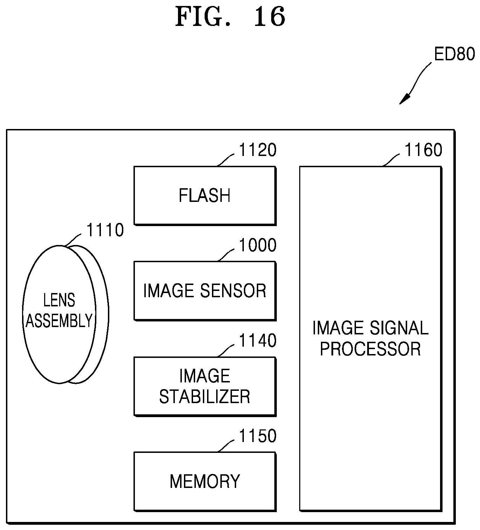

FIG. 16 is a block diagram showing an example of the camera module ED80 included in the electronic apparatus ED01 of FIG. 15. Referring to FIG. 16, the camera module ED80 may include a lens assembly 1110, a flash 1120, an image sensor 1000, an image stabilizer 1140, a memory 1150 (e.g., buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (e.g., viewing angle, focal distance, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (red-green-blue (RGB)) LED, white LED, infrared LED, ultraviolet LED, etc.), and/or a Xenon lamp. The image sensor 1000 may be the image sensor according to the embodiments described above, and converts the light emitted or reflected from the object and transferred through the lens assembly 1110 into an electrical signal to obtain an image corresponding to the object.

The image stabilizer 1140, in response to a motion of the camera module ED80 or the electronic apparatus 1101 including the camera module ED80, moves one or more lenses included in the lens assembly 1110 or the image sensor 1000 in a certain direction or controls the operating characteristics of the image sensor 1000 (e.g., adjusting of a read-out timing, etc.) in order to compensate for a negative influence of the motion. The image stabilizer 1140 may sense the movement of the camera module ED80 or the electronic apparatus ED01 by using a gyro sensor (not shown) or an acceleration sensor (not shown) arranged in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (e.g., Bayer-patterned data, high-resolution data, etc.) is stored in the memory 1150, and a low-resolution image is only displayed. Then, original data of a selected image (e.g., user selection, etc.) may be transferred to the image signal processor 1160. The memory 1150 may be integrated with the memory ED30 of the electronic apparatus ED01, or may include an additional memory that is operated independently.

The image signal processor 1160 may perform image treatment on the image obtained through the image sensor 1000 or the image data stored in the memory 1150. The image treatments may include a depth map generation, a three-dimensional modeling, a panorama generation, extraction of features, an image combination, and/or an image compensation (e.g., noise reduction, resolution adjustment, brightness adjustment, blurring, sharpening, softening, etc.). The image signal processor 1160 may perform controlling (exposure time control, read-out timing control, etc.) of the elements (e.g., image sensor 1000, etc.) included in the camera module ED80. The image processed by the image signal processor 1160 may be stored again in the memory 1150 for additional process, or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image treatment by the processor ED20 and then may be displayed on the display device ED60.

In one or more examples, the image signal processor 1160 may receive two output signals independently from the adjacent photosensitive cells in each pixel or sub-pixel of the image sensor, and may generate an auto-focusing signal from a difference between the two output signals. The image signal processor 1160 may control the lens assembly 1110 so that the focus of the lens assembly 1110 may be accurately formed on the surface of the image sensor based on the auto-focusing signal.

The electronic apparatus ED01 may further include one or a plurality of camera modules having different properties or functions. The camera module may include elements similar to those of the camera module ED80 of FIG. 16, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

## Claims

1. An image sensor (1000) comprising: a sensor layer (110C) including a plurality of pixels outputting pixel signals for generating an image; a meta-photonic structure (150) facing the sensor layer and including a plurality of nano-structures (NP); and a crack stopper (1121) disposed at a same layer as the meta-photonic structure (150) so as to surround the plurality of nano-structures (NP); an active pixel sensor region (1110) outputting a pixel signal for generating an image; and a periphery region (1200) surrounding the active pixel sensor region (1110), wherein the plurality of pixels of the sensor layer extend through the active pixel sensor region (1110) and the periphery region, wherein the active pixel sensor region (1110) comprises (i) the meta-photonic structure (150) facing the sensor layer, and (ii) a dielectric layer (DL), the meta-photonic structure (150) comprising the plurality of nano-structures (NP) arranged to have a meta pattern with the dielectric layer (DL) filled among the plurality of nano-structures (NP); wherein the periphery region comprises (i) the dielectric layer (DL) integrally extending from the active pixel sensor region (1110) and (ii) the crack stopper (1121) having a groove shape formed within the dielectric layer (DL).

2. The image sensor of claim 1, wherein
an interval between the crack stopper and the active pixel sensor region is ten times or greater than a width of each of the plurality of pixels.

3. The image sensor of claim 1 or 2, wherein
a width of the crack stopper is greater than or equal to a width of the nano-structure having a largest width from among the plurality of nano-structures, and optionally
a width of the crack stopper is 200 nm to 2 µm*.*

4. The image sensor of any preceding claim, wherein
an inside of the crack stopper is filled with a first material,
the plurality of nano-structures are filled with a second material, and
the first material is a same material as the second material.

5. The image sensor of any preceding claim, wherein
a bottom surface and at least one sidewall of the groove shape of the crack stopper are coated with a material of the plurality of nano-structures and a void remains at a center portion in the groove shape of the crack stopper after the bottom surface and the at least one sidewall of the groove shape of the crack stopper are coated.

6. The image sensor of any one of claim 1 to 5, wherein
the crack stopper is continuously extended along a circumference of the active pixel sensor region with an interval between the crack stopper and the active pixel sensor region.

7. The image sensor of any one of claim 1 to 6,
wherein the crack stopper is a first crack stopper surrounding the active pixel sensor region with a first interval between the active pixel sensor region and the first crack stopper, and
wherein the periphery region further comprises a second crack stopper surrounding the first crack stopper with a second interval between the first crack stopper and the second crack stopper.

8. The image sensor of any one of claim 1 to 7, wherein:
the periphery region comprises an optical black region that surrounds the active pixel sensor region and outputs a dark signal; and
the crack stopper is arranged in the optical black region.

9. The image sensor of claim 8, wherein
the meta-photonic structure of the active pixel sensor region is extended to a portion of the optical black region, and
the plurality of nano-structures in the meta-photonic structure in a portion of the optical black region are adjacent to a circumference of the active pixel sensor region, and optionally wherein
an interval between the nano-structure that is closest to the crack stopper and the crack stopper is ten times or greater than a width of each of the plurality of pixels.

10. The image sensor of claim 8 or 9, wherein:
the active pixel sensor region further includes a color filter layer between the sensor layer and the meta-photonic structure, and
the optical black region further includes a light shielding layer between the sensor layer and the dielectric layer, and optionally wherein
the optical black region further includes a blue color filter between the light shielding layer and the meta-photonic structure.

11. The image sensor of claim 10, wherein:
the active pixel sensor region and the optical black region each further include a planarization layer that extends from the active pixel sensor region to the optical black region;
in the active pixel sensor region, the planarization layer is disposed between the color filter layer and the meta-photonic structure; and
in the optical black region, the planarization layer is disposed between the light shielding layer and the dielectric layer.

12. The image sensor of any one of claim 1 to 11, wherein:
the meta-photonic structure includes a first meta-photonic structure layer having a plurality of first nano-structures and a second meta-photonic structure layer disposed on the first meta-photonic structure layer and having a plurality of second nano-structures;
the dielectric layer includes a first dielectric layer filled among the plurality of first nano-structures and a second dielectric layer filled among the plurality of second nano-structures; and
the first dielectric layer and the second dielectric layer are integrally extended from the active pixel sensor region to the periphery region, and optionally wherein
the crack stopper is a first crack stopper layer disposed in the first dielectric layer and the periphery region further comprises a second crack stopper layer disposed in the second dielectric layer, and further optionally wherein
one of the first crack stopper layer and the second crack stopper layer is continuously extended through the first dielectric layer and the second dielectric layer.

13. The image sensor of any one of claim 1 to 12, further comprising:
an anti-reflection layer disposed on an upper surface of the meta-photonic structure,
wherein the anti-reflection layer integrally extends from the active pixel sensor region to the periphery region, and the anti-reflection layer covers an upper surface of the crack stopper.

14. An electronic apparatus (ED01) comprising:
a lens assembly for forming an optical image of a subject; and
an image sensor according to any preceding claim configured to convert the optical image formed by the lens assembly into an electrical signal.

## Patentansprüche

1. Bildsensor (1000), umfassend: eine Sensorschicht (110C), die eine Vielzahl von Pixeln enthält, die Pixelsignale zum Erzeugen eines Bildes ausgeben; eine metaphotonische Struktur (150), die der Sensorschicht zugewandt ist und eine Vielzahl von Nanostrukturen (NP) enthält; und einen Rissstopper (1121), der auf einer gleichen Schicht wie die metaphotonische Struktur (150) so angeordnet ist, dass er die Vielzahl von Nanostrukturen (NP) umgibt; eine aktive Pixelsensorregion (1110), die ein Pixelsignal zum Erzeugen eines Bildes ausgibt; und eine Peripherieregion (1200), die die aktive Pixelsensorregion (1110) umgibt, wobei sich die Vielzahl von Pixeln der Sensorschicht über die aktive Pixelsensorregion (1110) und die Peripherieregion erstreckt, wobei die aktive Pixelsensorregion (1110) (i) die metaphotonische Struktur (150), die der Sensorschicht zugewandt ist, und (ii) eine dielektrische Schicht (DL) umfasst, wobei die metaphotonische Struktur (150) die Vielzahl von Nanostrukturen (NP) umfasst, die so angeordnet sind, dass sie ein Metamuster aufweisen, wobei die dielektrische Schicht (DL) zwischen die Vielzahl von Nanostrukturen (NP) gefüllt ist; wobei die Peripherieregion (i) die dielektrische Schicht (DL), die sich einstückig von der aktiven Pixelsensorregion (1110) erstreckt, und (ii) den Rissstopper (1121) umfasst, der eine Rillenform aufweist, die innerhalb der dielektrischen Schicht (DL) ausgebildet ist.

2. Bildsensor nach Anspruch 1, wobei
ein Abstand zwischen dem Rissstopper und der aktiven Pixelsensorregion das Zehnfache oder mehr einer Breite jedes der Vielzahl von Pixeln ist.

3. Bildsensor nach Anspruch 1 oder 2, wobei
eine Breite des Rissstoppers größer oder gleich einer Breite der Nanostruktur mit einer größten Breite aus der Vielzahl von Nanostrukturen ist und optional
eine Breite des Rissstoppers 200 nm bis 2 *µm* beträgt.

4. Bildsensor nach einem vorhergehenden Anspruch, wobei
ein Inneres des Rissstoppers mit einem ersten Material gefüllt ist,
die Vielzahl von Nanostrukturen mit einem zweiten Material gefüllt ist und
das erste Material ein gleiches Material wie das zweite Material ist.

5. Bildsensor nach einem vorhergehenden Anspruch, wobei
eine Bodenoberfläche und mindestens eine Seitenwand der Rillenform des Rissstoppers mit einem Material der Vielzahl von Nanostrukturen beschichtet sind und ein Hohlraum an einem mittleren Abschnitt in der Rillenform des Rissstoppers verbleibt, nachdem die Bodenoberfläche und die mindestens eine Seitenwand der Rillenform des Rissstoppers beschichtet wurden.

6. Bildsensor nach einem der Ansprüche 1 bis 5, wobei
der Rissstopper sich durchgängig entlang eines Umfangs der aktiven Pixelsensorregion mit einem Abstand zwischen dem Rissstopper und der aktiven Pixelsensorregion erstreckt.

7. Bildsensor nach einem der Ansprüche 1 bis 6,
wobei der Rissstopper ein erster Rissstopper ist, der die aktive Pixelsensorregion mit einem ersten Abstand zwischen der aktiven Pixelsensorregion und dem ersten Rissstopper umgibt, und
wobei die Peripherieregion ferner einen zweiten Rissstopper umfasst, der den ersten Rissstopper mit einem zweiten Abstand zwischen dem ersten Rissstopper und dem zweiten Rissstopper umgibt.

8. Bildsensor nach einem der Ansprüche 1 bis 7, wobei:
die Peripherieregion eine optisch schwarze Region umfasst, die die aktive Pixelsensorregion umgibt und ein Dunkelsignal ausgibt; und
der Rissstopper in der optisch schwarzen Region angeordnet ist.

9. Bildsensor nach Anspruch 8, wobei
die metaphotonische Struktur der aktiven Pixelsensorregion sich auf einen Abschnitt der optisch schwarzen Region erstreckt und
die Vielzahl von Nanostrukturen in der metaphotonischen Struktur in einem Abschnitt der optisch schwarzen Region an einen Umfang der aktiven Pixelsensorregion angrenzt und optional wobei
ein Abstand zwischen der Nanostruktur, die dem Rissstopper am nächsten ist, und dem Rissstopper das Zehnfache oder mehr einer Breite jedes der Vielzahl von Pixeln ist.

10. Bildsensor nach Anspruch 8 oder 9, wobei:
die aktive Pixelsensorregion ferner eine Farbfilterschicht zwischen der Sensorschicht und der metaphotonischen Struktur enthält und
die optisch schwarze Region ferner eine Lichtabschirmungsschicht zwischen der Sensorschicht und der dielektrischen Schicht enthält und optional wobei
die optisch schwarze Region ferner einen Blaufarbfilter zwischen der Lichtabschirmungsschicht und der metaphotonischen Struktur enthält.

11. Bildsensor nach Anspruch 10, wobei:
die aktive Pixelsensorregion und die optisch schwarze Region jeweils ferner eine Planarisierungsschicht enthalten, die sich von der aktiven Pixelsensorregion zu der optisch schwarzen Region erstreckt;
in der aktiven Pixelsensorregion die Planarisierungsschicht zwischen der Farbfilterschicht und der metaphotonischen Struktur angeordnet ist; und
in der optisch schwarzen Region die Planarisierungsschicht zwischen der Lichtabschirmungsschicht und der dielektrischen Schicht angeordnet ist.

12. Bildsensor nach einem der Ansprüche 1 bis 11, wobei:
die metaphotonische Struktur eine erste metaphotonische Strukturschicht, die eine Vielzahl von ersten Nanostrukturen aufweist, und eine zweite metaphotonische Strukturschicht, die auf der ersten metaphotonischen Strukturschicht angeordnet ist und eine Vielzahl von zweiten Nanostrukturen aufweist, enthält;
die dielektrische Schicht eine erste dielektrische Schicht, die zwischen die Vielzahl von ersten Nanostrukturen gefüllt ist, und eine zweite dielektrische Schicht, die zwischen die Vielzahl von zweiten Nanostrukturen gefüllt ist, enthält; und
die erste dielektrische Schicht und die zweite dielektrische Schicht sich einstückig von der aktiven Pixelsensorregion zu der Peripherieregion erstrecken und optional wobei
der Rissstopper eine erste Rissstopperschicht ist, die in der ersten dielektrischen Schicht angeordnet ist, und die Peripherieregion ferner eine zweite Rissstopperschicht umfasst, die in der zweiten dielektrischen Schicht angeordnet ist, und ferner optional wobei
eine von der ersten Rissstopperschicht und der zweiten Rissstopperschicht sich durchgängig über die erste dielektrische Schicht und die zweite dielektrische Schicht erstreckt.

13. Bildsensor nach einem der Ansprüche 1 bis 12, ferner umfassend:
eine Antireflexionsschicht, die auf einer oberen Oberfläche der metaphotonischen Struktur angeordnet ist,
wobei sich die Antireflexionsschicht einstückig von der aktiven Pixelsensorregion zu der Peripherieregion erstreckt und die Antireflexionsschicht eine obere Oberfläche des Rissstoppers bedeckt.

14. Elektronische Vorrichtung (ED01), umfassend:
eine Linsenanordnung zum Ausbilden eines optischen Bildes eines Subjekts; und
einen Bildsensor nach einem vorhergehenden Anspruch, der dazu konfiguriert ist, das optische Bild, das durch die Linsenanordnung ausgebildet wird, in ein elektrisches Signal umzuwandeln.

## Revendications

1. Capteur d'image (1000) comprenant : une couche de capteur (110C) comprenant une pluralité de pixels émettant des signaux de pixel pour générer une image ; une structure métaphotonique (150) faisant face à la couche de capteur et comprenant une pluralité de nanostructures (NP) ; et un arrêt de fissure (1121) disposé au niveau d'une même couche que la structure métaphotonique (150) de manière à entourer la pluralité de nanostructures (NP) ; une région de capteur de pixel actif (1110) émettant un signal de pixel pour générer une image ; et une région périphérique (1200) entourant la région de capteur de pixel actif (1110), dans lequel la pluralité de pixels de la couche de capteur s'étendent à travers la région de capteur de pixel actif (1110) et la région périphérique, dans lequel la région de capteur de pixel actif (1110) comprend (i) la structure métaphotonique (150) faisant face à la couche de capteur, et (ii) une couche diélectrique (DL), la structure métaphotonique (150) comprenant la pluralité de nanostructures (NP) agencées de manière à comporter un méta-motif avec la couche diélectrique (DL) remplie parmi la pluralité de nanostructures (NP) ; dans lequel la région périphérique comprend (i) la couche diélectrique (DL) s'étendant en un seul tenant à partir de la région de capteur de pixel actif (1110) et (ii) l'arrêt de fissure (1121) comportant une forme de rainure formée à l'intérieur de la couche diélectrique (DL).

2. Capteur d'image selon la revendication 1, dans lequel
un intervalle entre l'arrêt de fissure et la région de capteur de pixel actif est dix fois plus grand, ou plus, qu'une largeur de chacun de la pluralité de pixels.

3. Capteur d'image selon la revendication 1 ou 2, dans lequel
une largeur de l'arrêt de fissure est supérieure ou égale à une largeur de la nanostructure comportant la plus grande largeur parmi la pluralité de nanostructures, et éventuellement
une largeur de l'arrêt de fissure est de 200 nm à 2 *µm.*

4. Capteur d'image selon l'une quelconque des revendications précédentes, dans lequel
un intérieur de l'arrêt de fissure est rempli d'un premier matériau,
la pluralité de nanostructures sont remplies d'un deuxième matériau, et
le premier matériau est un même matériau que le deuxième matériau.

5. Capteur d'image selon l'une quelconque des revendications précédentes, dans lequel
une surface inférieure et au moins une paroi latérale de la forme de rainure de l'arrêt de fissure sont revêtues d'un matériau de la pluralité de nanostructures et il reste un vide au niveau d'une partie centrale dans la forme de rainure de l'arrêt de fissure une fois que la surface inférieure et l'au moins une paroi latérale de la forme de rainure de l'arrêt de fissure sont revêtues.

6. Capteur d'image de l'une quelconque des revendications 1 à 5, dans lequel
l'arrêt de fissure est étendu en continu le long d'une circonférence de la région de capteur de pixel actif avec un intervalle entre l'arrêt de fissure et la région de capteur de pixel actif.

7. Capteur d'image selon l'une quelconque des revendications 1 à 6,
dans lequel l'arrêt de fissure est un premier arrêt de fissure entourant la région de capteur de pixel actif avec un premier intervalle entre la région de capteur de pixel actif et le premier arrêt de fissure, et
dans lequel la région périphérique comprend en outre un second arrêt de fissure entourant le premier arrêt de fissure avec un second intervalle entre le premier arrêt de fissure et le second arrêt de fissure.

8. Capteur d'image selon l'une quelconque des revendications 1 à 7, dans lequel :
la région périphérique comprend une région noire optique qui entoure la région de capteur de pixel actif et émet un signal sombre ; et
l'arrêt de fissure est agencé dans la région noire optique.

9. Capteur d'image selon la revendication 8, dans lequel
la structure métaphotonique de la région de capteur de pixel actif est étendue jusqu'à une partie de la région noire optique, et
la pluralité de nanostructures dans la structure métaphotonique dans une partie de la région noire optique sont adjacentes à une circonférence de la région de capteur de pixel actif, et facultativement dans lequel
un intervalle entre la nanostructure qui est la plus proche de l'arrêt de fissure et l'arrêt de fissure est dix fois plus grand, ou plus, qu'une largeur de chacun de la pluralité de pixels.

10. Capteur d'image selon la revendication 8 ou 9, dans lequel :
la région de capteur de pixel actif comprend en outre une couche de filtre de couleur entre la couche de capteur et la structure métaphotonique, et
la région noire optique comprend en outre une couche de protection contre la lumière entre la couche de capteur et la couche diélectrique, et éventuellement dans lequel
la région noire optique comprend en outre un filtre de couleur bleue entre la couche de protection contre la lumière et la structure métaphotonique.

11. Capteur d'image selon la revendication 10, dans lequel :
la région de capteur de pixel actif et la région noire optique comprennent chacune en outre une couche de planarisation qui s'étend de la région de capteur de pixel actif à la région noire optique ;
dans la région de capteur de pixel actif, la couche de planarisation est disposée entre la couche de filtre de couleur et la structure métaphotonique ; et
dans la région noire optique, la couche de planarisation est disposée entre la couche de protection contre la lumière et la couche diélectrique.

12. Capteur d'image selon l'une quelconque des revendications 1 à 11, dans lequel :
la structure métaphotonique comprend une première couche de structure métaphotonique comportant une pluralité de premières nanostructures et une seconde couche de structure métaphotonique disposée sur la première couche de structure métaphotonique et comportant une pluralité de secondes nanostructures ;
la couche diélectrique comprend une première couche diélectrique remplie parmi la pluralité de premières nanostructures et une deuxième couche diélectrique remplie parmi la pluralité de deuxièmes nanostructures ; et
la première couche diélectrique et la seconde couche diélectrique sont étendues d'un seul tenant de la région de capteur de pixel actif à la région périphérique, et facultativement dans lequel
l'arrêt de fissure est une première couche d'arrêt de fissure disposée dans la première couche diélectrique et la région périphérique comprend en outre une seconde couche d'arrêt de fissure disposée dans la seconde couche diélectrique, et en outre éventuellement dans lequel
l'une de la première couche d'arrêt de fissure et de la seconde couche d'arrêt de fissure est étendue en continu à travers la première couche diélectrique et la seconde couche diélectrique.

13. Capteur d'image selon l'une quelconque des revendications 1 à 12, comprenant en outre :
une couche anti-reflet disposée sur une surface supérieure de la structure métaphotonique,
dans lequel la couche antireflet s'étend d'un seul tenant de la région de capteur de pixel actif à la région périphérique, et la couche antireflet couvre une surface supérieure de l'arrêt de fissure.

14. Appareil électronique (ED01), comprenant :
un ensemble lentille destiné à former une image optique d'un sujet ; et
un capteur d'image selon l'une quelconque des revendications précédentes configuré pour convertir l'image optique formée en un signal électrique.
